# EUROPEAN PATENT APPLICATION

(11) **EP 1 830 392 A2**
(43) Date of publication of application: **05.09.2007**
(21) Application number: 07250868.2
(22) Date of filing: 01.03.2007
(51) Int. Cl.: H01L 21/00

(54) **Thermal processing system with accross-flow liner**

(30) Priority: 26.01.2007 US 627474; 01.03.2006 US 777853 P
(71) Applicant: Aviza Technology, Inc., Scotts Valley, CA 95066 (US)
(72) Inventor: Qui, Taiquing T., Los Gatos California 95032 (US); Bailey, Robert J., Santa Cruz California 95066 (US); Treichel, Helmuth, Milpitas California 95035 (US)
(74) Representative: Dunlop, Brian Kenneth Charles

(57) **Abstract**

An apparatus is provided for thermally processing substrates held in a carrier. The apparatus includes an across-flow liner to improve gas flow uniformity across the surface of each substrate. The across-flow liner of the present invention includes a longitudinal bulging section to accommodate a across-flow injection system. The liner is patterned and sized so that it is conformal to the wafer carrier, and as a result, reduces the gap between the liner and the wafer carrier to reduce or eliminate vortices and stagnation in the gap areas between the wafer carrier and the liner inner wall.

## Description

### CROSS REFERENCE TO RELATED APPLICATIONS

This application claims the benefit of and priority to U.S. Patent Application Serial Number 11/627,474 filed January 26, 2007 and U.S. Provisional Patent Application No. 60/777,853 filed March 1, 2006, the contents of all of which are hereby incorporated by reference in their entirety.

### TECHNICAL FIELD

The present invention relates generally to systems and methods for heat treating objects, such as substrates and more particularly to an apparatus and method for simultaneously and uniformly processing a stack of semiconductor wafer substrates by heat treating, annealing, depositing layers of material on, or removing a layer of material therefrom.

### BACKGROUND

Thermal processing apparatuses are commonly used in the manufacture of integrated circuits (ICs) or semiconductor devices from semiconductor substrates or wafers. Thermal processing of semiconductor wafers include, for example, heat treating, annealing, diffusion or driving of dopant material into the semiconductor substrate, deposition or growth of layers of material on the substrate surface, and etching or removal of material from the wafer surface. These processes often call for the wafer to be heated to a temperature as high as 1300°C and as low as 300°C or below before and during the process, and that one or more precursors, such as a process gas or reactant, be delivered to the wafer. Moreover, these processes typically require the wafer be maintained at a uniform temperature throughout the process, despite variations in the temperature of the process gas or the rate at which it is introduced into the process chamber.

A conventional thermal processing apparatus typically consists of a voluminous process chamber positioned in or surrounded by a furnace. Substrates to be thermally processed are sealed in the process chamber, which is then heated by the furnace to a desired temperature at which time the processing is performed. For many processes, such as Chemical Vapor Deposition (CVD), the sealed process chamber is first evacuated, and once the process chamber has reached the desired temperature, reactive or process gases are introduced to form or deposit reactant species on the substrates.

Conventional thermal processing apparatuses typically require guard heaters disposed adjacent to the sidewalls of the process chamber above and below the process zone in which product wafers are processed. This arrangement is undesirable since it entails a larger chamber volume that must be pumped down, filled with process gas or vapor, and backfilled or purged, resulting in increased processing time. Moreover, this configuration takes up a tremendous amount of space and power due to a poor view factor of the wafers from the heaters.

Another problem with conventional thermal processing apparatuses includes the considerable time required both before processing to ramp up the temperature of the process chamber and the wafers to be treated to a desired level, and the time required after processing to ramp the temperature down. Furthermore, additional time is often required to ensure the temperature of a process chamber has uniformly stabilized at a desired temperature before processing can begin. While the actual time required for processing of the wafers may be 30 minutes or less, pre- and post- processing times typically take 1 to 3 hours or longer. Thus, the time required to heat up and/or cool down the process chamber to a uniform temperature significantly limits the throughput of a conventional thermal processing apparatus.

A fundamental reason for the relatively long ramp up and ramp down times is the thermal mass of the process chamber and/or the furnace in a conventional thermal processing apparatus, which must be heated or cooled prior to effectively heating or cooling the wafer.

A common approach to minimizing or offsetting this limitation on throughput of processed wafers through conventional thermal processing apparatuses has been to increase the number of wafers capable of being processed in a single cycle or process run. Simultaneous processing of a large number of wafers helps to maximize the effective throughput of the apparatus by reducing the effective processing time on a per wafer basis. However, this approach also increases the magnitude of the risk should something go wrong during processing. That is, a larger number of wafers may be destroyed or damaged by a single failure, for example, an equipment or process failure during a processing run. This is particularly a concern with larger wafer sizes and more complex integrated circuits where a single wafer could be valued from $1,000 to $10,000 or more, depending on the stage of processing.

Yet another problem with increasing the quantity of wafers processed in a single run is that increasing the size of the process chamber to accommodate a larger number of wafers increases the thermal mass of the process chamber, thereby reducing the rate at which the wafer can be heated or cooled. Moreover, larger process chambers processing relatively large batches of wafers leads to or compounds a "first-in-last-out" syndrome. This syndrome is caused by the first wafers loaded into the chamber being the last wafers removed, thereby resulting in these wafers being exposed to elevated temperatures for longer periods and reducing uniformity across the batch of wafers.

Still yet another problem with conventional thermal processing apparatuses is an increase in the non-uniformity across a batch of wafers, both with respect to a wafer-to-wafer comparison and a location-to-location comparison for a single wafer. This increase in non-uniformity results from inadequate mixing of the process or reactant gases and non-uniform flow of the gas across the wafer surfaces. The inadequate mixing results from insufficient gas injector systems. The non-uniform flow of a process or reactant gas across a wafer surface is promoted by gaps and vacant spaces between the process chamber or liner and the wafers. These gaps and spaces allow for vortices and stagnation of the gas flow.

Accordingly, there is a need for an apparatus and method for quickly and uniformly processing a batch of substrates to a desired temperature across the surface of each substrate in the batch during thermal processing to anneal, deposit a layer, or remove a layer from the batch of substrates. There is also a need for an apparatus and method to increase the uniformity of the deposition onto, or removal of, wafer substrates subject to thermal processing.

### SUMMARY OF THE INVENTION

The present invention provides a solution to these and other problems, and offers other advantages over the prior art and has utility in substrate processing with particular benefit in the areas of semiconductor and solar cell production.

The present invention provides an apparatus and method for isothermally heating work pieces, such as semiconductor substrates or wafers, and for performing processes such as annealing, diffusion or driving of dopant material into the wafer substrate, deposition or growth of layers of material on the wafer substrate, and etching and removal of material from the wafer surface.

A thermal processing apparatus is provided for processing substrates held in a carrier at high or elevated temperatures. The apparatus includes a process chamber having a top wall, a side wall and a bottom wall, and a heating source having a number of heating elements proximal to the top wall, the side wall and the bottom wall of the process chamber to provide an isothermal environment in a process zone in which the carrier is positioned to thermally process the substrates. In the alternative, the apparatus has a number of heating elements proximal only to the top wall and the side wall of the process chamber. Within the process chamber is an across-flow liner, which the carrier with or without wafers can be inserted into. According to one aspect, the dimensions of the across-flow liner are selected to enclose a volume substantially no larger than a volume necessary to accommodate the carrier, and the process zone extends substantially throughout the across-flow liner. Preferably, the across-flow liner has dimensions selected to enclose a volume substantially no larger than 125% of that necessary to accommodate the carrier. More preferably, the apparatus further includes a pumping system to evacuate the process chamber prior to processing, and a purge system to backfill the process chamber after processing is complete. The dimensions of the across-flow liner and the process chamber are selected to provide both a rapid evacuation and a rapid backfilling of the process chamber.

According to another aspect of the present invention, the across-flow liner improves reactant gas(es) mixing and gas flow uniformity across the surface of each substrate and the exhaust of unreacted reactant gas(es) and byproducts. The across-flow liner of the present invention includes a longitudinal bulging section to accommodate a vertical orificed injector. The liner is patterned and sized so that it is conformal to the wafer carrier and thereby reduces the gap between the liner and the wafer carrier. As a result, the vortices and stagnation in the gap regions that cause reduced gas mixing and non-uniform gas flow are reduced or eliminated. Through adjustment of the displacement of injectors each having a series of vertically spaced orifices and exhaust apertures around a central wafer carrier or boat, control is exerted to promote intrasubstrate and intersubstrate process uniformity.

And in yet another embodiment of the present invention, the position of the gas inlet injection system is adjustable and thereby allows for various reactant gas mixing and gas flow variations.

### BRIEF DESCRIPTION OF THE DRAWINGS

These and various other features and advantages of the present invention will be apparent upon reading of the following detailed description in conjunction with the accompanying drawings and the appended claims provided below, where:

FIG. 1 is a cross-sectional view of a thermal processing apparatus having a pedestal heater for providing an isothermal control volume according to an embodiment of the present invention, employing conventional up-flow configuration;

FIG. 2 is a perspective view of an alternative embodiment having a base-plate useful in the thermal processing apparatus shown in FIG. 1;

FIG. 3 is a cross-sectional view of a portion of a thermal processing apparatus having a pedestal heater and a thermal shield according to an embodiment of the present invention;

FIG. 4 is a diagrammatic illustration of the pedestal heater and thermal shield of FIG. 3 according to an embodiment of the present invention;

FIG. 5 is a diagrammatic illustration of an embodiment of the thermal shield having a top layer of material with a high absorptivity and a lower layer of material with a high reflectivity according to present invention;

FIG. 6 is a diagrammatic illustration of another embodiment of the thermal shield having a cooling channel according to present invention;

FIG. 7 is a perspective view of an embodiment of a thermal shield and an actuator according to present invention;

FIG. 8 is a cross-sectional view of a portion of a thermal processing apparatus having a shutter according to an embodiment of the present invention;

FIG. 9 is a cross-sectional view of a process chamber having a pedestal heater and a magnetically coupled/ferrofluidic coupled wafer rotation system according to an embodiment of the present invention;

FIG. 10 is a cross-sectional view of a thermal processing apparatus having an across-flow injector system according to an embodiment of the present invention;

FIG. 11 is a cross-sectional side view of a portion of the thermal processing apparatus of FIG. 10 along angle ψ of FIG. 13 showing positions of injector orifices in relation to the liner and of exhaust slots in relation to the wafers according to an embodiment of the present invention;

FIG. 12 is a plan view of a portion of the thermal processing apparatus of FIG. 10 taken along the line A-A of FIG. 10 showing gas flow from orifices of a primary injector at an angle α of 0 degrees and a secondary injector at an angle β of 180 degrees relative to the substrate center across a wafer and to an exhaust port according to an embodiment of the present invention;

FIG. 13 is a plan view of a portion of the thermal processing apparatus of FIG. 10 taken along the line A-A of FIG. 10 showing gas flow from orifices of a primary injector at an angle α of 180 degrees and a secondary injector at an angle β of 180 degrees relative to the substrate center across a wafer and to an exhaust port;

FIG. 14 is a plan view of a portion of the thermal processing apparatus of FIG. 10 taken along the line A-A of FIG. 10 showing gas flow from orifices of a primary injector at an angle α of 75 degrees and a secondary injector at an angle β of 75 degrees relative to the substrate center across a wafer and to an exhaust port;

FIG. 15 is a plan view of a portion of the thermal processing apparatus of FIG. 10 taken along the line A-A of FIG. 10 showing gas flow from orifices of a primary injector at an angle α of 0 degrees and a secondary injector at an angle β of 0 degrees relative to the substrate center across a wafer and to an exhaust port;

FIG. 16 is a cross-sectional view of a thermal processing apparatus having an alternative up-flow injector system according to an embodiment of the present invention;

FIG. 17 is a cross-sectional view of a thermal processing apparatus having an alternative down-flow injector system according to an embodiment of the present invention;

FIG. 18 is flowchart showing an embodiment of a process for thermally processing a batch of wafers according to an embodiment of the present invention whereby each wafer of the batch of wafers is quickly and uniformly heated to the desired temperature;

FIG. 19 is flowchart showing another embodiment of a process for thermally processing a batch of wafers according to an embodiment of the present invention whereby each wafer of the batch of wafers is quickly and uniformly heated to the desired temperature;

FIG. 20 is a cross-sectional view of a thermal processing apparatus including an across-flow liner according to one embodiment of the present invention;

FIG. 21 is a perspective external view of an across-flow stepped liner showing a longitudinal bulging section according to one embodiment of the present invention;

FIG. 22 is a perspective external view of an across-flow stepped liner reverse that of FIG. 21 showing a plurality of exhaust slots in the liner according to one embodiment of the present invention;

FIG. 23 is a side view of an across-flow liner in accordance with one embodiment of the present invention;

FIG. 24 is a top plan view of an across-flow liner in accordance with one embodiment of the present invention;

FIG. 25 is a partial top plan view of an across-flow liner in accordance with one embodiment of the present invention;

FIG. 26 is a perspective inverted view of one embodiment of an across-flow injection system;

FIG. 27 is a perspective inverted view of another embodiment of an across-flow injection system;

FIG. 28 is a plan view of an across-flow liner with a bulging section showing gas flow from orifices of a first injector at an angle α of 180 degrees and orifices of a second injector at an angle β of 180 degrees relative to a substrate center that impinges the liner inner wall prior to flowing across a wafer and exiting an exhaust slot in opposition to the bulging section;

FIG. 29 is a plan view of an across-flow liner with a bulging section showing gas flow from orifices of a first injector at an angle α of 110 degrees and orifices of a second injector at an angle P of 110 degrees relative to a substrate center that impinges each other prior to flowing across a wafer and exiting an exhaust slot in opposition to the bulging section;

FIG. 30 is a plan view of an across-flow liner with a bulging section showing gas flow from orifices of a first injector at an angle α of 0 degrees and orifices of a second injector at an angle β of 0 degrees relative to a substrate center directing to the center of a wafer and exiting an exhaust slot in opposition to the bulging section;

FIGS. 31 and 32 are particle trace graphical representations showing gas flow lines across the surface of a wafer inside a chamber including an across-flow liner having a bulging section (FIG. 31) and a circular cross section (FIG. 32) and two injectors each having injection orifices defining an angle relative to the wafer center of 180 degrees where the flow from the orifice of the left injector is ten times that of the right injector and identical flows in FIGS. 31 and 32;

FIGS. 33 and 34 are particle trace graphical representations showing gas flow lines across the surface of a wafer inside a chamber including an across-flow liner having a bulging section (FIG. 33) and a circular cross section (FIG. 34) and two injectors each having injection orifices defining an angle relative to the wafer center of 75 degrees where the flow from the orifice of the left injector is ten times that of the right injector and identical flows in FIGS. 33 and 34;

FIGS. 35 and 36 are particle trace graphical representations showing gas flow lines across the surface of a wafer inside a chamber including an across-flow liner having a bulging section (FIG. 35) and a circular cross section (FIG. 36) and two injectors each having injection orifices defining an angle relative to the wafer center of 0 degrees where the flow from the orifice of the left injector is ten times that of the right injector and identical flows in FIGS. 35 and 36;

FIG. 37 is a side view of the across-flow liner shown in cross section in FIGS. 28-31, 33 and 35;

FIG. 38 is a cross-sectional view of the across-flow liner of FIG. 37 along line 38A-38B showing a heat shield in accordance with one embodiment of the present invention where angle ψ defines the center of the exhaust slot above the depicted view;

FIG. 39 is a magnified cross-sectional inset view of the circled portion of FIG. 38;

FIG. 40 is a partially transparent side view showing an elongated injector forming an h-tube in an across-flow liner having a bulging section;

FIG. 41 is a magnified cross-sectional view of the notched injector engagement opening in the open end of the liner shown in FIG. 40;

FIG. 42 is a computational fluid dynamics (CFD) demonstration for a thermal processing apparatus including an across-flow liner and an injection system as shown in FIG. 28 flowing bis tertbutylamino silane (BTBAS) from the left injector and ammonia from the right injector;

FIG. 43 is CFD demonstration for a thermal processing apparatus including an across-flow liner and an injection system as shown in FIG. 29 flowing from BTBAS and ammonia from the right and left injectors, respectively;

FIG. 44 is CFD demonstration for a thermal processing apparatus including an across-flow liner and an injection system as shown in FIG. 30 flowing BTBAS and ammonia from the right and left injectors, respectively;

FIG. 45 is an exploded view of the interface between various sized vertical injectors and base-plates of an inventive thermal processing system;

FIG. 46 is a perspective semitransparent view of an inventive liner;

FIG. 47 is a cross-sectional view of the inventive liner depicted in FIG. 46;

FIG. 48 is a schematic depicting trace lines derived from computational fluid dynamic studies and showing a wafer zone of high reactivity for a thermal processing system employing the liner of FIG. 46;

FIG. 49 is a schematic depicting trace lines derived from computational fluid dynamic studies and showing a wafer zone of high reactivity for a thermal processing system employing the liner of FIG. 36;

FIG. 50 is a perspective semitransparent cutaway view of an inventive liner having a bulging section accommodating each of the injectors;

FIG. 51 is a cross-sectional view of the inventive liner depicted in FIG. 50;

FIG. 52 is a perspective semitransparent cutaway view of an inventive liner; and

FIG. 53 is a cross-sectional view of the inventive liner depicted in FIG. 52.

### DETAILED DESCRIPTION OF THE INVENTION

The present invention is directed to an apparatus and method for processing a relatively small number or mini-batch of one or more work pieces, such as semiconductor substrates or wafers, held in a carrier, such as a cassette or boat, that provides reduced processing cycle times and improved process uniformity. In the alternative, the present invention is directed to an apparatus and method for processing a large number or large batch of one or more work pieces, and provides reduced processing cycle times and improved process uniformity.

By thermal processing it is meant processes in which the work piece or wafer is heated to a desired temperature which is typically in the range of about 350°C to 1300°C, and can include temperatures as low as 75°C. For illustrative purposes only, thermal processing of semiconductor wafers can include heat treating, annealing, diffusion or driving of dopant material into the wafer substrates, deposition or growth of layers of material on the wafer surface via, for example, chemical vapor deposition (CVD) and etching or removal of material from the wafer substrates.

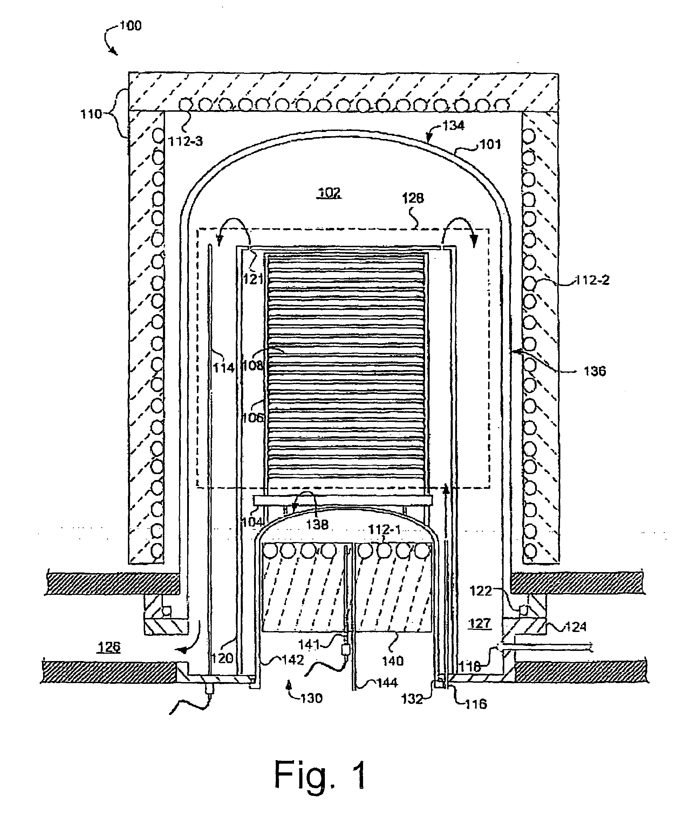

A thermal processing apparatus according to an embodiment will now be described with reference to FIG. 1. For purposes of clarity, many of the details of thermal processing apparatuses that are widely known and are widely known to a person of skill in the art have been omitted. Such detail is described in more detail in, for example, commonly assigned U.S. Patent No. 4,770,590, which is incorporated herein by reference.

FIG. 1 is a cross-sectional view of an embodiment of a thermal processing apparatus for thermally processing a batch of semiconductor wafers. As shown, the thermal processing apparatus 100 generally includes a vessel 101 that encloses a volume to form a process chamber 102 having a support 104 adapted for receiving a carrier or boat 106 with a batch of wafers 108 held therein, and heat source or furnace 110 having a number of heating elements 112-1, 112-2 and 112-3 (referred to collectively hereinafter as heating elements 112) for raising a temperature of the wafers to the desired temperature for thermal processing. The thermal processing apparatus 100 further includes one or more optical or electrical temperature sensing elements, such as a resistance temperature device (RTD) or thermocouple (T/C), for monitoring the temperature within the process chamber 102 and controlling operation of the heating elements 112. In the embodiment shown in FIG. 1, the temperature sensing element is a profile T/C 114 that has multiple independent temperature sensing nodes or points (not shown) for detecting the temperature at multiple locations within the process chamber 102. The thermal processing apparatus 100 also includes one or more injectors 116 (only one of which is shown) for introducing a fluid, such as a gas or vapor, into the process chamber 102 for processing or cooling the wafers 108, and one or more purge ports or vents 118 (only one of which is shown) for introducing a gas to purge the process chamber and cool the wafers. A liner 120 increases the concentration of processing gas or vapor near the wafers 108 in a process zone 128 in which the wafers are processed, and reduces contamination of the wafers from flaking or peeling of deposits that can form on interior surfaces of the process chamber 102. Processing gas or vapor exits the process zone through exhaust ports or slots 121 in the chamber liner 120.

Generally, the vessel 101 is sealed by a seal, such as an o-ring 122, to a platform or base-plate 124 to form the process chamber 102, which completely encloses the wafers 108 during thermal processing. The dimensions of the process chamber 102 and the base-plate 124 are selected to provide a rapid evacuation, rapid heating and a rapid backfilling of the process chamber. Advantageously, the vessel 101 and the base-plate 124 are sized to provide a process chamber 102 having dimensions selected to enclose a volume substantially no larger than necessary to accommodate the liner 120 with the carrier 106 and wafers 108 held therein. Preferably, the vessel 101 and the base-plate 124 are sized to provide a process chamber 102 having dimensions of from about 125 to about 150% of that necessary to accommodate the liner 120 with the carrier 106 and wafers 108 held therein, and more preferably, the process chamber has dimensions no larger than about 125% of that necessary to accommodate the liner 120 and the carrier 106 and wafers 108 in order to minimize the chamber volume and thereby reduce pump down and back-fill time required.

Openings for the injectors 116, T/Cs 114 and vents 118 are sealed using seals such as o-rings, VCR®, or CF® fittings. Gases or vapor released or introduced during processing are evacuated through a foreline or exhaust port 126 formed in a wall of the process chamber 102 (not shown) or in a plenum 127 of the base-plate 124, as shown in FIG. 1. The process chamber 102 can be maintained at atmospheric pressure during thermal processing or evacuated to a vacuum as low as 5 millitorr through a pumping system (not shown) including one or more roughing pumps, blowers, hi-vacuum pumps, and roughing, throttle and foreline valves. In the alternative, the process chamber can be evacuated to a vacuum lower than 5 millitorr.

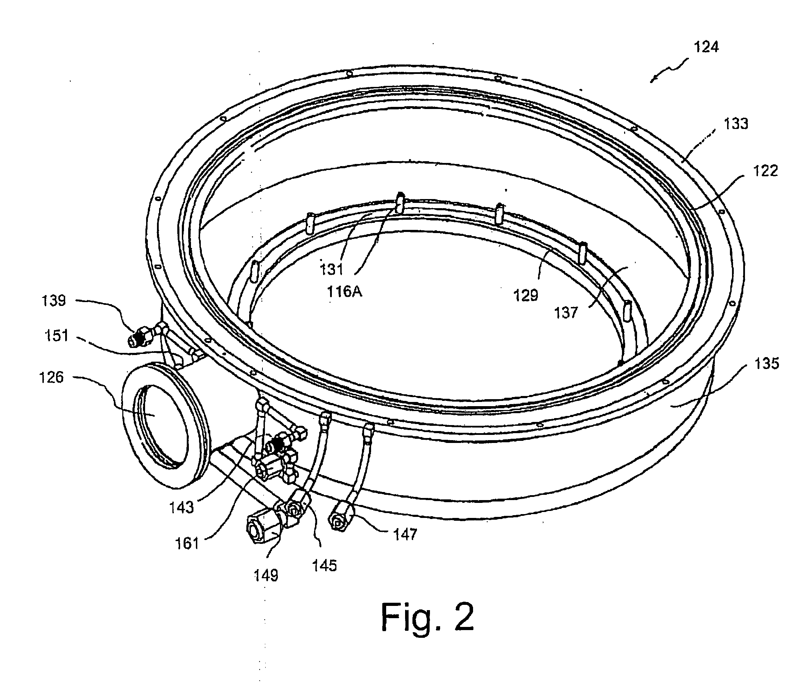

As shown in FIG. 2, the base-plate 124 further includes a substantially annular flow channel 129 adapted to receive and support an injector 116 including a ring 131 from which depend a number of vertical injector tube or injectors 116A. The injectors 116A can be sized and shaped to provide an up-flow, down-flow or across-flow flow pattern, as described below. The ring 131 and injectors 116A are located so as to inject the gas into the process chamber 102 between the boat 106 and the vessel 101. In addition, the injectors 116A are spaced apart around the ring 131 to uniformly introduce process gas or vapor into the process chamber 102, and may, if desired, be used during purging or backfilling to introduce a purge gas into the process chamber. The base-plate 124 is sized in a short cylindrical form with an outwardly extending upper flange 133, a sidewall 135, and an inwardly extending base 137. The upper flange 133 is adapted to receive and support the vessel 101, and contains an o-ring 122 to seal the vessel to the upper flange. The base 137 is adapted to receive and support the liner 120 between the ring 131 of injectors 116 and the sidewall 135.

Additionally, the base-plate 124 shown in FIG. 2 incorporates various ports including backfill or purge gas inlet ports 139 and 143, cooling ports 145 and 147 which provide cooling fluid to the base-plate 124, and a pressure monitoring port 149 for monitoring pressure within the process chamber 102. Process gas inlet ports 151 and 161 introduce a gas from a gas supply (not shown) to the injectors 116A. The backfill or purge ports 139 and 143 are provided at the sidewall 135 of the base-plate 124 principally to introduce a gas from a vent or purge gas-supply (not shown) to the vents 118. A mass flow controller (not shown) or any other suitable flow controller is placed in line between the gas supplies and the ports 139, 143, 151 and 161 to control the gas flow into the process chamber 102.

The vessel 101 and liner 120 can be made of any metal, ceramic, crystalline or glass material that is capable of withstanding the thermal and mechanical stresses of high temperature and high vacuum operation, and which is resistant to erosion from gases and vapors used or released during processing. Preferably, the vessel 101 and liner 120 are made from an opaque, translucent or transparent quartz glass having a sufficient thickness to withstand the mechanical stresses of the thermal processing operation and resist deposition of process byproducts. By resisting deposition of process byproducts, the vessel 101 and liner 120 reduce the potential for contamination of the processing environment. More preferably, the vessel 101 and liner 120 are made from quartz that reduces or eliminates the conduction of heat away from the process zone 128 in which the wafers 108 are processed.

The batch of wafers 108 is introduced into the thermal processing apparatus 100 through a load lock or loadport (not shown) and then into the process chamber 102 through an access or opening in the process chamber or base-plate 124 capable of forming a gas tight seal therewith. In the configuration shown in FIG. 1, the process chamber 102 is a vertical reactor and the access utilizes a movable pedestal 130 that is raised during processing to seal with a seal, such as an o-ring 132 on the base-plate 124, and lowered to enable an operator or an automated handling system, such as a boat handling unit (BHU) (not shown), to position the carrier or boat 106 on the support 104 affixed to the pedestal.

The heating elements 112 include elements positioned proximal to a top 134 (elements 112-3), side 136 (elements 112-2) and bottom 138 (elements 112-1) of the process chamber 102. In the alternative, heating elements 112 do not include elements positioned proximal to the bottom 138 of the process chamber 102. Advantageously, the heating elements 112 surround the wafers to achieve a good view factor of the wafers and thereby provide an isothermal process zone 128 in the process chamber in which the wafers 108 are processed. The heating elements 112-1 proximal to the bottom 138 of the process chamber 102 can be disposed in or on the pedestal 130. If desired, additional heating elements may be disposed in or on the base plate 124 to supplement heat from the heating elements 112-1.

In the embodiment shown in FIG. 1 the heating elements 112-1 proximal to the bottom of the process chamber 102 preferably are recessed in the movable pedestal 130. The pedestal 130 is made from a thermally and electrically insulating material or insulating block 140 having electric, resistive heating elements 112-1 embedded therein or affixed thereto. The pedestal 130 further includes one or more T/Cs 141 used to control the heating elements 112-1. In the configuration shown, the T/Cs 141 are embedded in the center of the insulating block 140.

The side heating elements 112-2 and the top heating elements 112-3 may be disposed in or on an insulating block 110 about the vessel 101. Preferably the side heating elements 112-2 and the top heating elements 112-3 are recessed in the insulating block 110.

Preferably, to attain desired processing temperatures of up to 1150°C the heating elements 112-1 proximal to the bottom 138 of the process chamber 102 have a maximum power output of from about 0.1 kW to about 10 kW with a maximum process temperature of at least 1150°C. More preferably, these bottom heating elements 112-1 have a power output of at least about 3.8 kW with a maximum process temperature of at least 950°C. In one embodiment, the side heating elements 112-2 are functionally divided into multiple zones, each of which are capable of being operated independently at different power levels and duty cycles from each other. The heating elements 112 are controlled in any suitable manner.

Contamination from the insulating block 140 and bottom heating elements 112-1 is reduced if not eliminated by housing the heating element and insulation block in an inverted quartz crucible 142, which serves as a barrier between the heating element and insulation block and the process chamber 102. The crucible 142 is also sealed against any external environment to further reduce or eliminate contamination of the processing environment. Generally, the interior of the crucible 142 is at standard atmospheric pressure and should be strong enough to withstand a pressure differential of as much as 1 atmosphere.

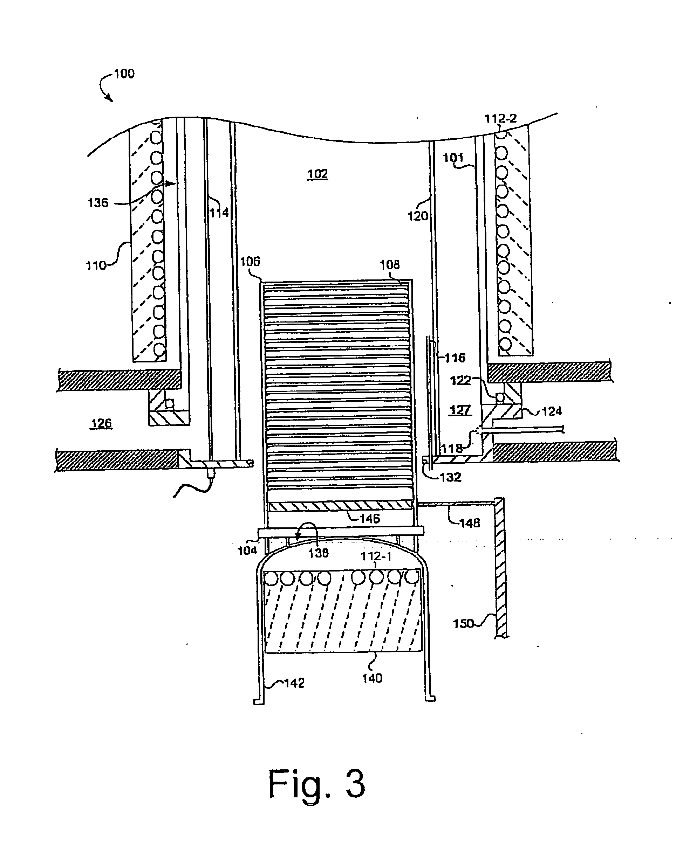

While the wafers 108 are being loaded or unloaded, that is while the pedestal 130 is in the lowered position (FIG. 3), the bottom heating elements 112-1 are powered to maintain an idle temperature lower than the desired processing temperature. For example, for a process having a desired processing temperature for the bottom heating elements of 950°C, the idle temperature can be from 50-150°C. The idle temperature can be set higher for certain processes, such as those having a higher desired processing temperature or higher desired ramp-up rate. A higher idle temperature can be employed to reduce thermal cycling effects on the bottom heating elements 112-1, thereby extending element life.

In order to further reduce preprocessing time, that is the time required to prepare the thermal processing apparatus 100 for processing, the bottom heating elements 112-1 can be ramped to or held at an elevated preprocess temperature during the push or load, that is while the pedestal 130 with a boat 106 of wafers 108 positioned thereon is being raised. However, to minimize thermal stresses on the wafers 108 and components of the thermal processing apparatus 100 it is preferred to have the bottom heating elements 112-1 reach the desired process temperature at the same time as the heating elements 112-2 and 112-3 located proximal to the top 136 and side 134 respectively, of the process chamber 102. Thus, for some processes, such as those requiring higher desired process temperatures, ramping up of bottom heating elements 112-1 can be initiated before the pedestal 130 is raised, for example while the last of the wafers 108 in a batch are being loaded.

Similarly, it will be appreciated that after processing and during the pull or unload cycle, that is while the pedestal 130 is being lowered, power to the bottom heating elements 112-1 can be reduced or removed completely to begin ramping down the pedestal 130 to the idle temperature.

To assist in cooling the pedestal 130 to a pull temperature prior to the pull or unload cycle, a purge line for air or an inert purge gas, such as nitrogen, is installed through the insulating block 140. Preferably, nitrogen is injected through a passage 144 through the center of the insulating block 140 and allowed to flow out between the top of the insulating block 140 and the interior of the crucible 142 to a perimeter thereof. The hot nitrogen is then exhausted to the environment either through High Efficiency Particulate Air (HEPA) filter (not shown) or to a facility exhaust (not shown). This center injection configuration facilitates the faster cooling of the center of the wafers 108, and therefore is ideal to minimize the center/edge temperature differential of the bottom wafer or wafers.

As noted above, to increase or extend the life of bottom heating element 112-1 the idle temperature can be set higher and thus closer to the desired processing temperature and thereby reduce the effects of thermal cycling. In addition, it is also desirable to periodically bake out the heating elements 112-1 in an oxygen-rich environment to promote the formation of a protective oxide surface coat. For example, where the resistive heating elements are formed from an aluminum containing alloy, such as Kanthal®, baking out the heating elements 112-1 in an oxygen rich environment promotes an aluminum oxide surface growth. Thus, the insulating block 140 can further include an oxygen line (not shown) to promote the formation of the protective oxide surface coat during bake out of the heating elements 112-1. Alternatively, oxygen for bake out can be introduced through the passage 144 used during processing to supply cooling nitrogen via a three-way valve.

FIG. 3 is a cross-sectional view of a portion of a thermal processing apparatus 100. FIG. 3 shows the thermal processing apparatus 100 while the wafers 108 are being loaded or unloaded while the pedestal 130 is in the lowered position. In this mode of operation, the thermal processing apparatus 100 further includes a thermal shield 146 that can be rotated or slid into place between the pedestal 130 and the lower wafer 108 in the boat 106. To improve the performance of the thermal shield 146, generally the thermal shield is reflective on the side facing the heating elements 112-1 and absorptive on the side facing the wafers 108. Purposes of the thermal shield 146 include increasing the rate of cooling of the wafers 108, and assisting in maintaining the idle temperature of the pedestal 130, thereby decreasing the time required to ramp up the process chamber 102 to a desired processing temperature. An embodiment of a thermal processing apparatus having a thermal shield will now be described in further detail with reference to FIGS. 3 through 6.

In the embodiment shown in FIG. 3, the thermal shield 146 is attached via an arm 148 to a rotable shaft 150. Rotable shaft 150 is turned by an electric, pneumatic or hydraulic actuator and allows thermal shield 146 to be rotated into a first position between the pedestal 130 and the wafers 108 in the boat 106 during the pull or unload cycle, and rotated to a second position not between the pedestal 130 and the wafers 108. Preferably, the rotable shaft 150 is mounted on or affixed to the mechanism (not shown) used for raising and lowering the pedestal 130, thereby enabling the thermal shield 146 to be rotated into position as soon as the top of the pedestal has cleared the process chamber 102. Having the shield 146 in place during a load cycle enables the heating elements 112-1 to be heated to a desired temperature more rapidly than would otherwise be possible. Similarly, during an unload cycle the shield 146 helps in cooling the wafers 108, particularly those closer to the pedestal 130, by reflecting the heat radiating from the pedestal heating elements 112-1.

Alternatively, the rotable shaft 150 can be mounted on or affixed to another part of the thermal processing apparatus 100 and adapted to move axially in synchronization with the pedestal 130, or to rotate the thermal shield 146 into position only when the pedestal is fully lowered.

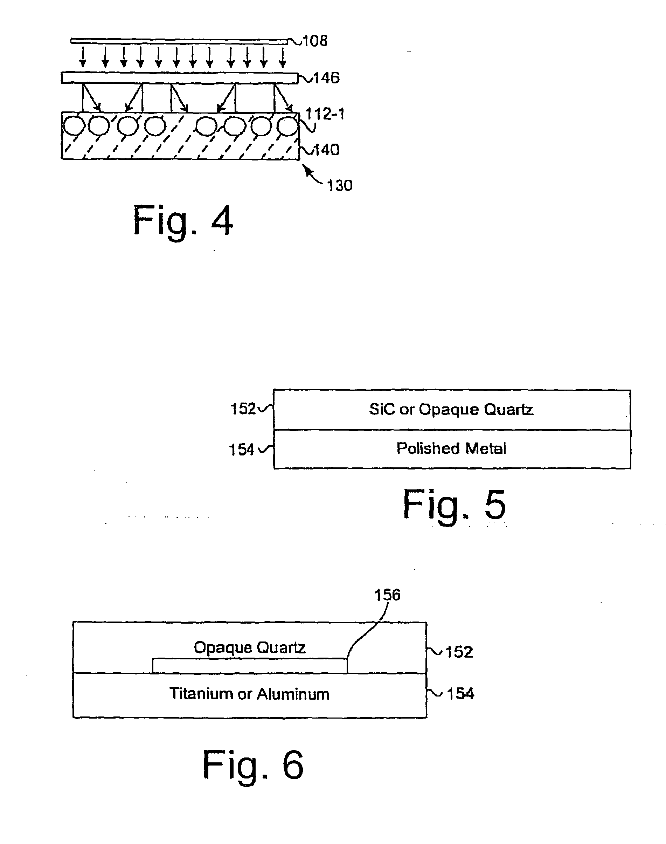

FIG. 4 is a diagrammatic illustration of the pedestal heating elements 112-1 and thermal shield 146 of FIG. 3 illustrating the reflection of thermal energy or heat radiating from the bottom heating elements back to the pedestal 130 and the absorption of thermal energy or heat radiating from the lower wafer 108 in the batch of wafers. It has been determined that the desired characteristics, high reflectivity and high absorptivity, can be obtained using a number of different materials, such as metals, ceramic, glass or polymeric coatings, either individually or in combination. By way of example the following table lists various suitable materials and corresponding parameters.

**Table I**

| **Material** | **Absorptivity** | **Reflectivity** |
|---|---|---|
| Stainless Steel | 0.2 | 0.8 |
| Opaque Quartz | 0.5 | 0.5 |
| Polished Aluminum | 0.03 | 0.97 |
| Silicon Carbide | 0.9 | 0.1 |

According to one embodiment the thermal shield 146 can be made from a single material such as silicon-carbide (SiC), opaque quartz or stainless steel which has been polished on one side and scuffed, abraded or roughened on the other. Roughening a surface of the thermal shield 146 can significantly change its heat transfer properties, particularly its reflectivity.

In another embodiment, the thermal shield 146 can be made from two different layers of material. FIG. 5 is a diagrammatic illustration of a thermal shield 146 having a top layer 152 of material (with a high absorptivity), such as SiC or opaque quartz, and a lower layer 154 of material (with a high reflectivity), such as polished stainless steel or polished aluminum. Although shown as having approximately equal thicknesses, it will be appreciated that the top layer 152 and the lower layer 154 can have different thicknesses depending on specific requirements for the thermal shield 146, such as minimizing thermal stresses between the layers due to differences in coefficients of thermal expansion. For example, in certain embodiments the lower layer 154 can be an extremely thin layer or film of polished metal deposited, formed or plated on a quartz plate that forms the top layer 152. The materials can be integrally formed or interlocking, or joined by conventional means such as bonding or fasteners.

In yet another embodiment, FIG. 6 shows the thermal shield 146 with an internal cooling channel 156 to further insulate the wafers 108 from the bottom heating elements 112-1. In one version of this embodiment, the cooling channel 156 is formed between two different layers of material. For example, the cooling channel 156 can be formed by milling or any other suitable technique in a highly absorptive opaque quartz layer 152, and be covered by a metal layer 154. Alternatively, the cooling channel 156 can be formed in the metal layer 154 or both the metal layer and the quartz layer 152.

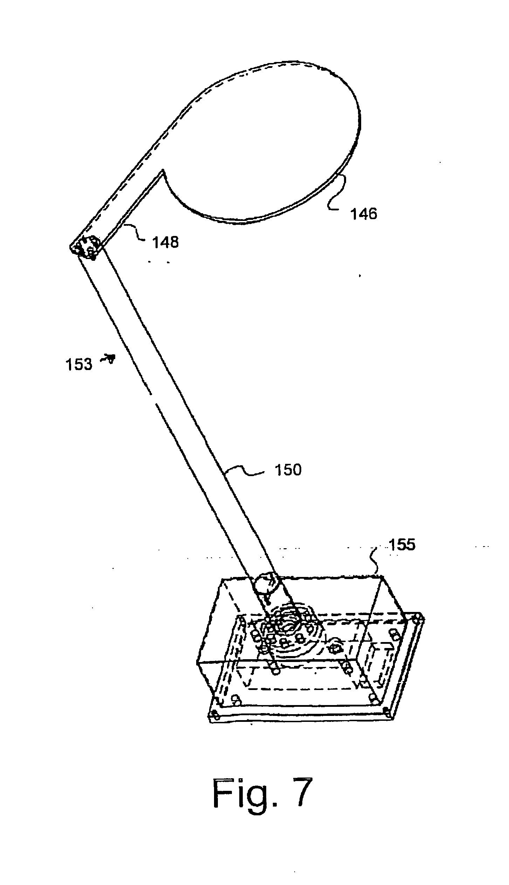

FIG. 7 is a perspective view of an embodiment of a thermal shield assembly 153 including the thermal shield 146, arm 148, rotable shaft 150 and an actuator 155.

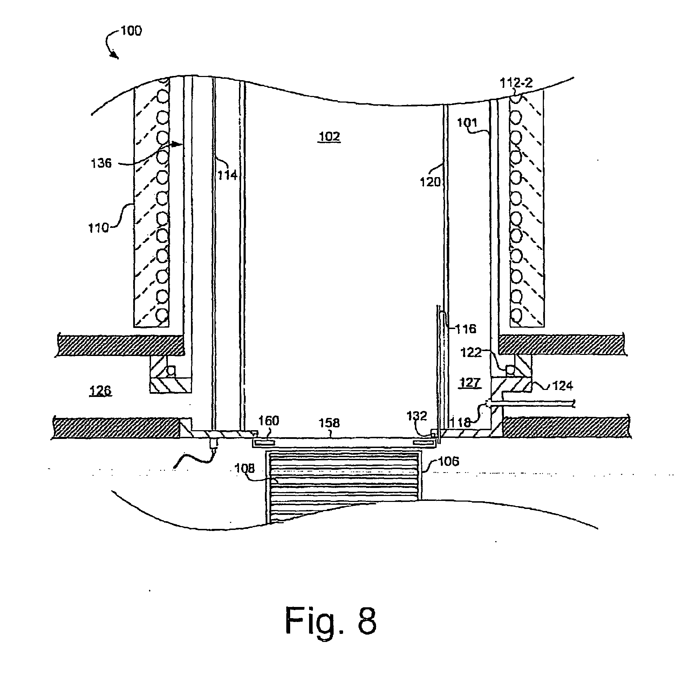

As shown in FIG. 8, the thermal processing apparatus 100 can further include a shutter 158 that can be rotated, slid or otherwise moved into place above the boat 106 to isolate the process chamber 102 from the outside or load port environment when the pedestal 130 is in the fully lowered position. For example, the shutter 158 can be slid into place above the carrier 106 when the pedestal 130 is in a lowered position, and raised to isolate the process chamber 102. Alternatively, the shutter 158 can be rotated or swung into place above the carrier 106 when the pedestal 130 is in a lowered position, and subsequently raised to isolate the process chamber 102. Optionally, the shutter 158 may be rotated about or relative to threaded screw or rod to simultaneously raise the shutter to isolate the process chamber 102 as it is swung into place above the carrier 106.

For a process chamber 102 that is normally operated under vacuum, such as in a CVD system, the shutter 158 could form a vacuum seal against the base-plate 124 to allow the process chamber 102 to be pumped down to the process pressure or vacuum. For example, it may be desirable to pump down the process chamber 102 between sequential batches of wafers to reduce or eliminate the potential for contaminating the process environment. Forming a vacuum seal is preferably done with a large diameter seal, such as an o-ring, and thus the shutter 158 can desirably include a number of water channels 160 to cool the seal. In the embodiment shown in FIG. 8 the shutter 158 seals with the same o-ring 132 used to seal with the crucible 142 when the pedestal 130 is in the raised position.

For a thermal processing apparatus 130 in which the process chamber 102 is normally operated at atmospheric pressure, the shutter 158 is simply an insulating device used to reduce heat loss from the bottom of the process chamber. One embodiment for accomplishing this involves the use of an opaque quartz plate, which mayor may not further include a number of cooling channels underneath or internal thereto.

When the pedestal 130 is in the fully lowered position, the shutter 158 is moved into position below the process chamber 102 and then raised to isolate the process chamber by one or more electric, hydraulic or pneumatic motors (not shown).

Preferably, the motor is a pneumatic motor using from about 15 to 60 pounds per square inch gauge (PSIG) air, which is commonly available on the thermal processing apparatus 100 for operation of pneumatic valves. For example, in one version of this embodiment the shutter 158 can comprise a plate having a number of wheels attached via short arms or cantilevers to two sides thereof (not shown). In operation, the plate or shutter 158 is rolled into position beneath the process chamber 102 on two parallel guide rails (not shown). Stops on the guide rails then cause the cantilevers to pivot translating the motion of the shutter 158 into an upward direction to seal the process chamber 102.

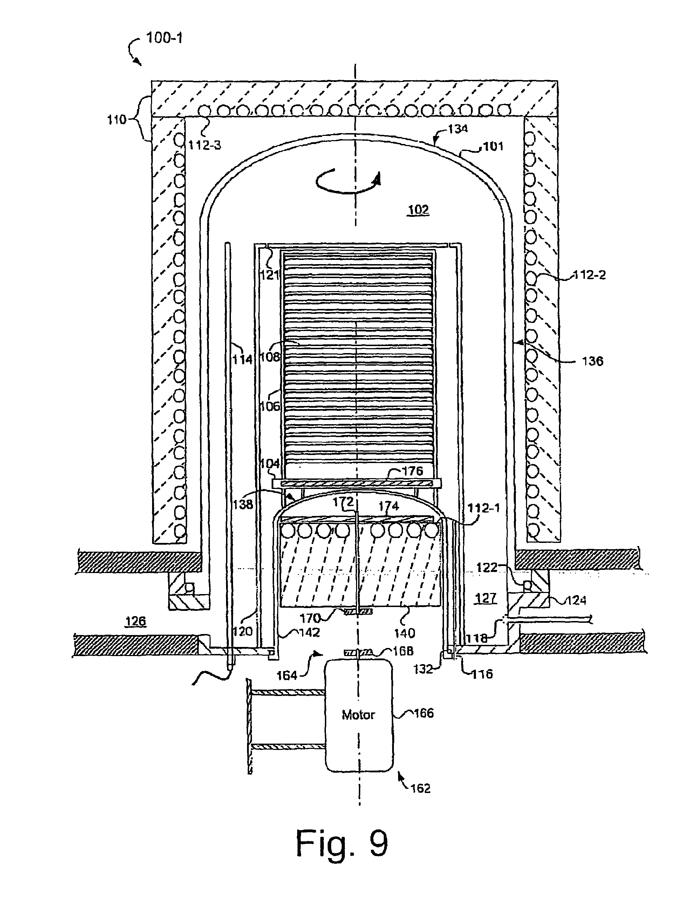

As shown in FIG. 9, the thermal processing apparatus 100, where like numerals correspond to those detailed with respect to the previous figures, further includes a magnetically coupled wafer rotation system 162 that rotates the support 104 and the boat 106 along with the wafers 108 supported thereon during processing. In the alternative, the thermal apparatus 100 uses a rotational ferrofluidics seal (not shown) to rotate the support 104 and the boat 106 along with the wafers 108 supported thereon during processing. Rotating the wafers 108 during processing improves within wafer (WIW) uniformity by averaging out any non-uniformities in temperature and process gas flow to create a uniform wafer temperature and species reaction profile. Generally, the wafer rotation system 162 is capable of rotating the wafers 108 at a speed of from about 0.1 to about 10 revolutions per minute (RPM).

The wafer rotation system 162 includes a drive assembly or rotating mechanism 164 having a rotating motor 166, such as an electric or pneumatic motor, and a magnet 168 encased in a chemically resistive container, such as annealed polytetrafluoroethylene or stainless steel. A steel ring 170 located just below the insulating block 140 of the pedestal 130, and a drive shaft 172 with the insulating block transfer the rotational energy to another magnet 174 located above the insulating block in a top portion of the pedestal. The steel ring 170, drive shaft 172 and second magnet 174 are also encased in a chemically resistive container compound. The magnet 174 located inside of the pedestal 130 magnetically couples through the crucible 142 with a steel ring or magnet 176 embedded in or affixed to the support 104 in the process-chamber 102.

A ferrofluidic coupling is provided between the rotating mechanism 164 and the pedestal 130.

In addition to the above, the wafer rotation system 162 can further include one or more sensors (not shown) to ensure proper boat 106 position and proper magnetic coupling between the steel ring or magnet 176 in the process chamber 102 and the magnet 174 in the pedestal 130. A boat position verification sensor which determines the relative position of the boat 106 is particularly useful. In one embodiment, the boat position verification sensor includes a sensor protrusion (not shown) on the boat 106 and an optical or laser sensor located below the base-plate 124. In operation, after the wafers 108 have been processed the pedestal 130 is lowered about 3 inches below the base-plate 124. There, the wafer rotation system 162 is commanded to turn the boat 106 until the boat sensor protrusion can be seen. Then, the wafer rotation system 162 is operated to align the boat so that the wafers 108 can be unloaded. After this is done, the boat is lowered to the load/unload height.

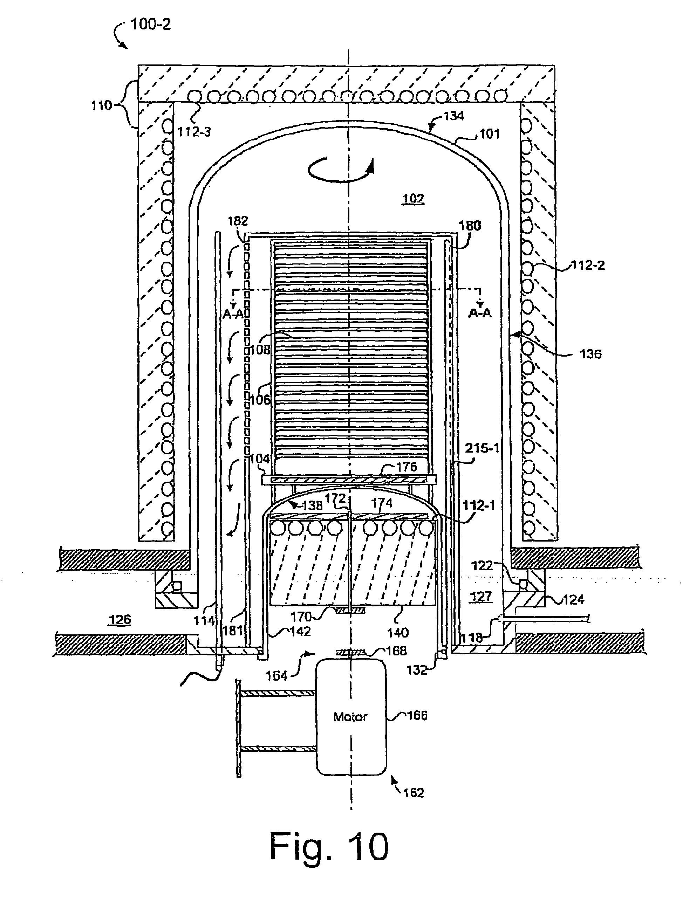

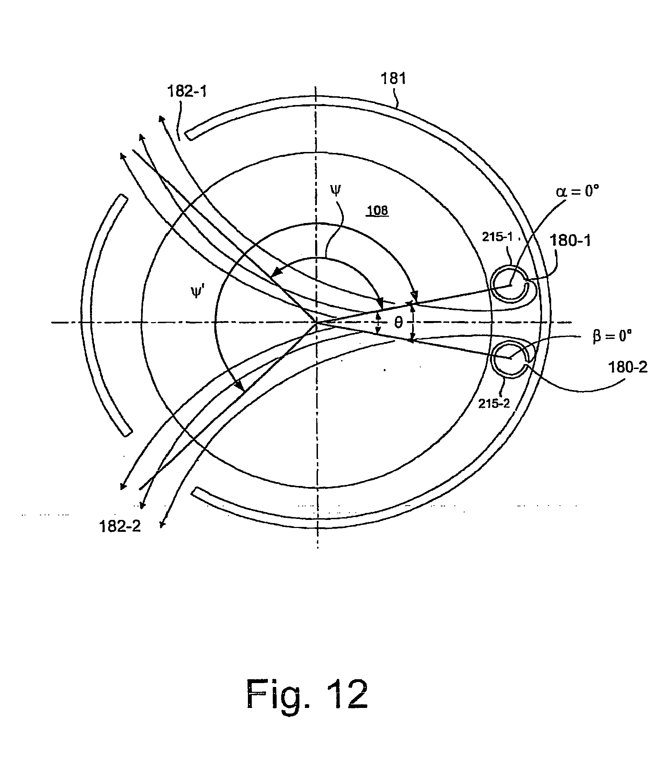

As shown in FIGS. 10-15, inventive injectors collectively 215 are preferably used in the thermal processing apparatus 100-2. The injectors 215, of which two are depicted, are distributive or across-flow injectors 215-1 and 215-2 that process gas or vapor introduced through injector orifices 180 on one side of the wafers 108 held in boat 106 and caused to flow across the surfaces of the wafers 108 in a laminar flow to exhaust ports or slots 182 in liner 181. The exhaust ports or slots 182 are depicted as two courses of ports or slots 182-1 and 182-2 that are positioned at angles ψ and ψ' relative to a first injector 215-1 through the center of a wafer 108. It is appreciated that the number of courses of vertically displaced exhaust ports or slots 182 is one, two, or more with each defining an angle ψⁿ where n is the number of the course of exhaust ports or slots 182-n where ψ angles increase in degrees with each successive course such that ψ<ψ'<ψ²...ψⁿ. Preferably there are 1 to 3 inclusive vertical courses of exhaust ports or slots. While the exhaust slots 182-1 and 182-2 are depicted at angles ψ and ψ¹ of about 115 degrees and 235 degrees, respectively, an inventive liner is readily formed with a course or courses of exhaust ports or slots 182 at various other angles. Additionally, while 182-1 and 182-2 shown in FIGS. 12-15 are depicted as equal width slots, it is appreciated that the dimensions of a course of exhaust slots or ports formed in a linear are optionally made different than that depicted in FIGS. 12-15 and varied relative to any other course of exhaust slots or ports. Further, circular or other non-rectilinear shaped ports are formed in combination with, or in place of, slots in a given exhaust course. The across-flow injectors 215-1 and 215-2 improve wafer uniformity within a batch of wafers 108 by providing an improved distribution of process gas or vapor over earlier gas flow configurations. Preferably, the injector orifices 180 are aligned with wafer support positions to promote each wafer 108 receiving a similar fluid flow across the surface regardless of wafer vertical position within the wafer batch in the inventive liner.

Additionally, across-flow injectors collectively 215 can serve purposes other than reactant fluid gas or vapor delivery, including the injection of gases (e.g., helium, nitrogen, hydrogen) for forced convective cooling between the wafers 108. Use of across-flow injectors collectively 215 results in a more uniform cooling between wafers 108 whether disposed at the bottom, top or middle of the stack of wafers, as compared with prior art gas flow configurations. Preferably, the injector 215 orifices 180 are sized, shaped and positioned to provide a spray pattern that promotes forced convective cooling between the wafers 108 in a manner that does not create a large temperature gradient across the wafer.

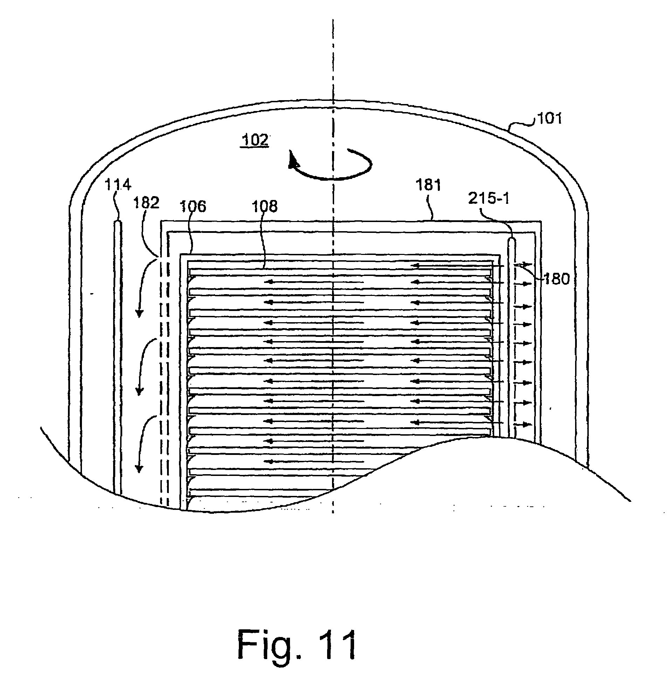

FIG. 11 is a cross-sectional side view of a portion of the thermal processing apparatus 100 of FIG. 10" showing illustrative portions of the injector orifices 180 in relation to the liner 181 and the exhaust ports or slots 182 in relation to the wafers 108.

FIG. 12 is a plan view of a portion of the thermal processing apparatus 100-2 of FIG. 10 taken along the line A-A of FIG. 10 showing laminar gas flow from the orifices 180-1 and 180-2 of primary and secondary injectors 215-1, 215-2, across an illustrative one of the wafers 108 and to exhaust slots 182-1 and 182-2 according to one embodiment. It should be noted that the position of the exhaust slot 182 as shown in FIGS. 10 and 11 is shown along angle ψ to allow illustration of the exhaust ports or slots and injectors 215-1 in a single cross-sectional view of a thermal processing apparatus. It should also be noted that the dimensions of the injectors 215-1, 215-2, and the exhaust slots 182-1 and 182-2 relative to the wafer 108 and the chamber liner 181 have been exaggerated to more clearly illustrate the gas flow from the injectors to the exhaust slots.

Also as shown in FIG. 12, the process gas or vaporfrom injector 215-1 is directed towards the wafer 108 while injector 215-2 is directed away from the wafers 108 and toward the liner 181 to promote mixing of the process gas or vapor before it reaches the wafers. An angle α of 0 degrees is defined through the center of injector 215-1 extending between the orifice 180-1 and the center of wafer 108. Likewise an angle β of 180 degrees is defined about the center of injector 215-2 between 180-2 and the wafer center. This configuration of orifices 180-1 and 180-2 is particularly useful for processes or recipes in which different reactants that vary significantly in molecular weight are introduced from each of the primary and secondary injectors 215-1, 215-2, for example to form a multi-component film or layer.

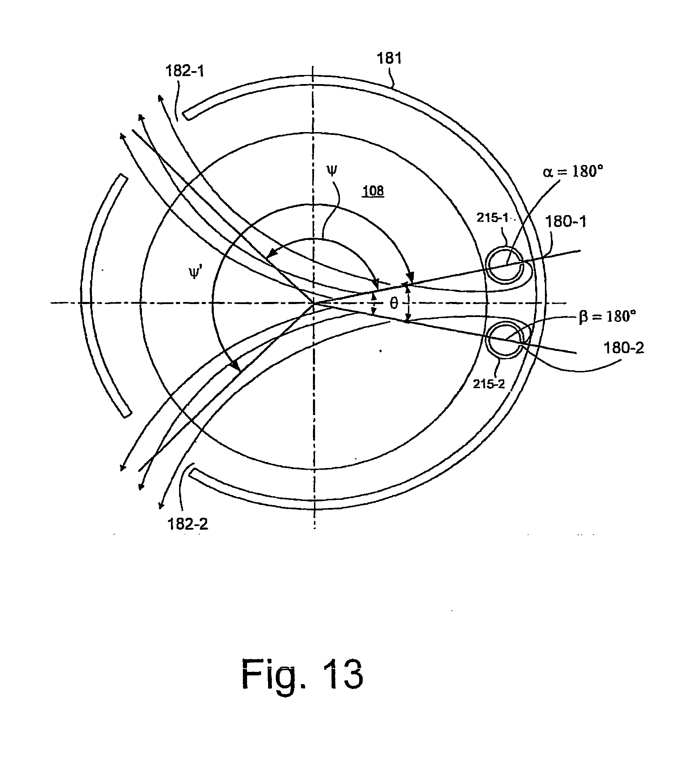

FIG. 13 is a plan view of a portion of the thermal processing apparatus 100-2 of FIG. 10 taken along the line A-A of FIG. 10 showing an alternative gas flow path from the orifices 180 of the primary and secondary injector 215-1, 215-2, across an illustrative one of the wafers 108 and to the exhaust slots 182-1 and 182-2 in which the angles α and β are both 180 degrees.

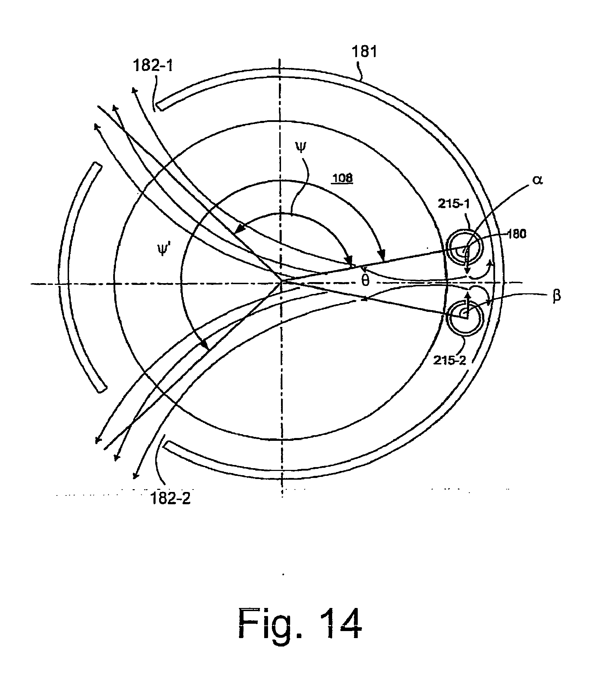

FIG. 14 is another plan view of a portion of the thermal processing apparatus 100-2 of FIG. 10 taken along the line A-A of FIG. 10 showing an alternative gas flow path from the orifices 180 of the primary and secondary injector 215-1, 215-2, across an illustrative one of the wafers 108 and to the exhaust slots 182-1 and 182-2 in which angles α and β are both 75 degrees.

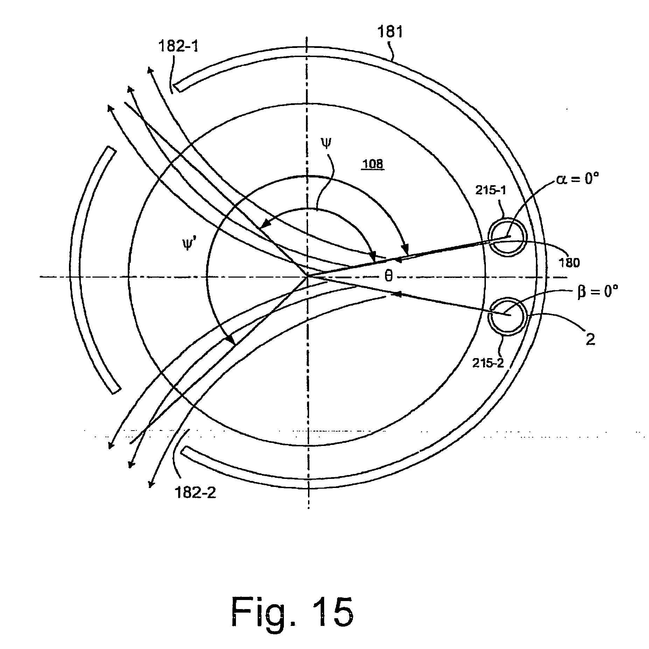

FIG. 15 is another plan view of a portion of the thermal processing apparatus 100-2 of FIG. 10 taken along the line A-A of FIG. 10 showing an alternative gas flow path from the orifices 180 of the primary and secondary injector 215-1, 215-2, across an illustrative one of the wafers 108 and to the exhaust slots 182-1 and 182-2 in which angles α and β are both 0 degrees.

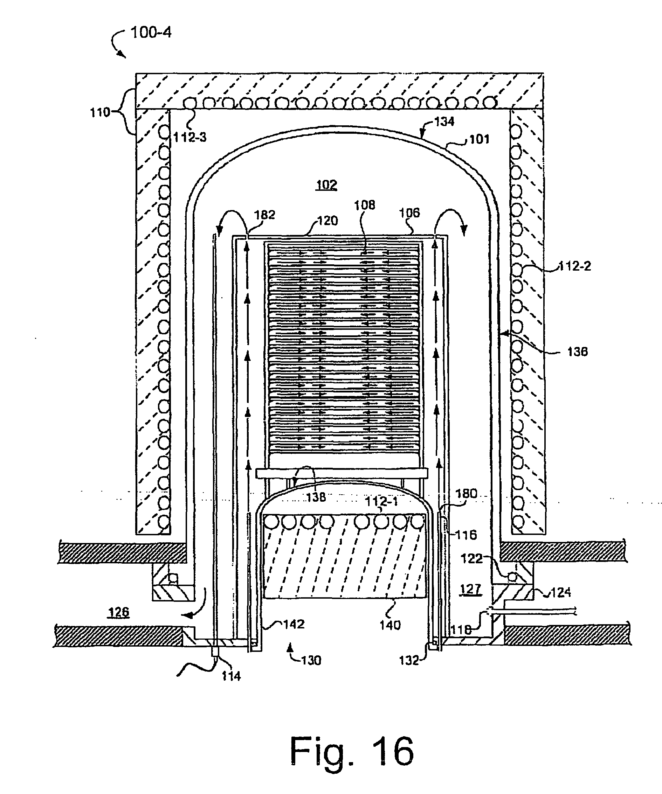

FIG. 16 is a cross-sectional view of a thermal processing apparatus 100-3 having two or more up-flow injectors 116-1 and 116-2 according to an alternative embodiment. In this embodiment, process gas or vapor admitted from the process injectors 116-1 and 116-2 having respective outlet orifices low in the process chamber 102 flows up and across the wafers 108, and spent gases exit exhaust slots 182 in the top of the liner 120. An up-flow injector system is also shown in FIG. 1.

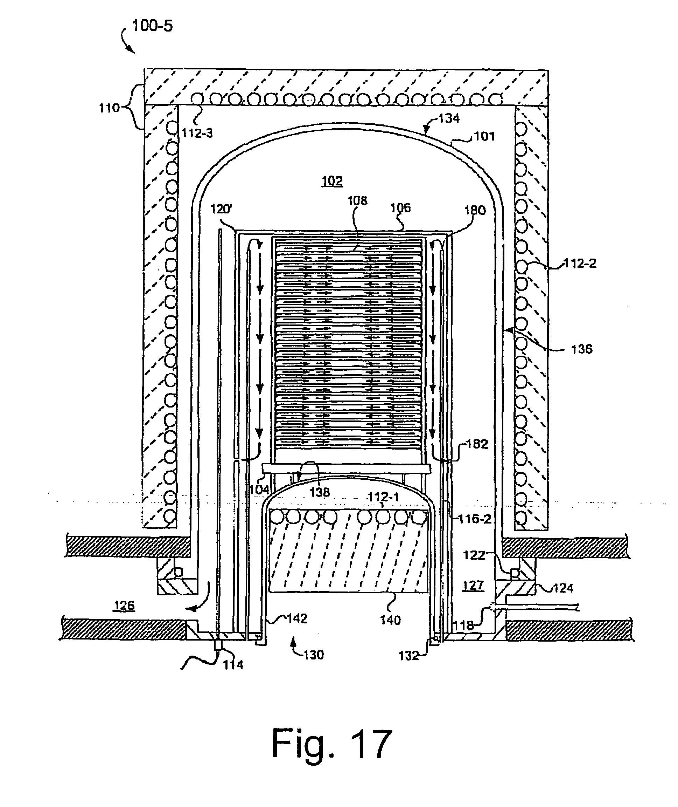

FIG. 17 is a cross-sectional view of a thermal processing apparatus 100-4 having a down-flow injector system according to an alternative embodiment. In this embodiment, process gas or vapor admitted from process injectors 116-1 and 116-2 having respective orifices high in the process chamber 102 flows down and across the wafers 108, and spent gases exit exhaust slots 182 in the lower portion of the liner 120'.

Advantageously, the injectors 116, collectively numbered at 215, and/or the liners 120 or 181 are quickly and easily replaced or swapped with other injectors and liners having different points for the injection and exhausting of the process gas from the process zone 128. It will be appreciated by those skilled in the art that the embodiment of the across-flow injector 215 shown in FIG. 10 adds a degree of process flexibility by enabling the flow pattern within the process chamber 102 to be quickly and easily changed. This can be accomplished through the use of easily installable injector assemblies 215 and liners 181 to convert the flow geometry from cross-flow to an up-flow, etc., as well as adjust the across-flow fluid paths over a wafer substrate. The position, angle (α with respect to injector 215-1), diameter and relative number of injectors are readily modified. A base-plate as detailed in FIG. 2 is provided with a series of apertures adapted to receive injectors so as to facilitate positional change of an injector relative to exhaust ports or slots and other injectors if present. A representative factor to be considered in injector position relative to other injectors is reaction rate of fluids exiting the injectors under processing conditions. The injector angle defined through the center of an injector between the wafer center and the center of a series of injector orifices, denoted as angle α with respect to injector 215-1 in FIGS. 12-15, is adjusted through injector rotation so as to seat an index pin with a complementary notch in the liner or base plate. It is appreciated that adjustment of injector orifice rotation angle is also optionally achieved with conventional tube securement techniques capable of forming a gas-tight seal such as through use of a circumferential clamp ring, , a key simultaneously engaging an injector, a liner base, and a frinction fit.

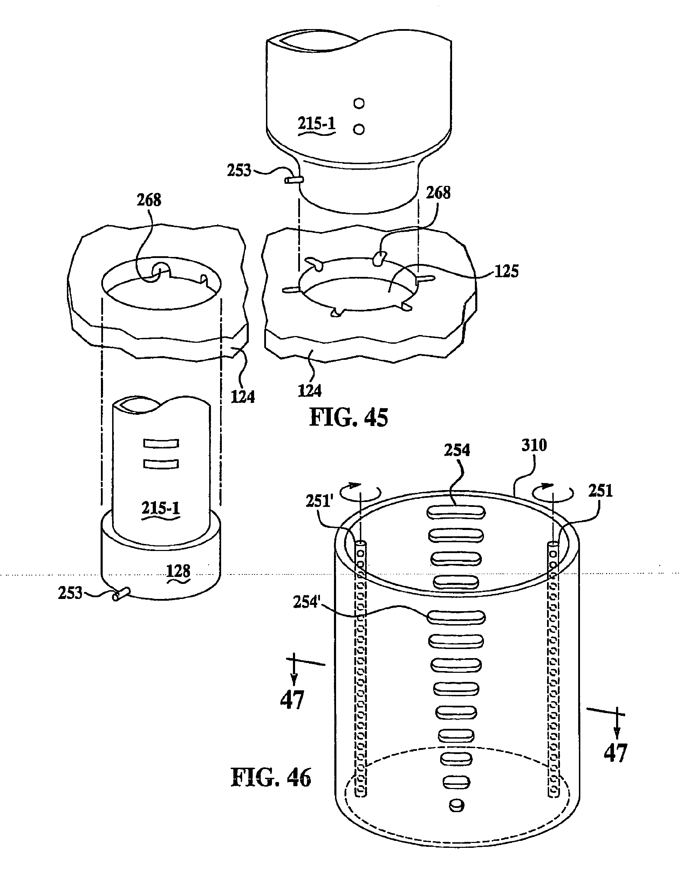

A different diameter injector is accommodated through the enlargement of injector engagement aperture 125 to accommodate the outer diameter of the enlarged injector in instances when the injector outer diameter is greater than that of an existing aperture in the base 124 engaging an inventive liner. Alternatively, an injector tapers to a diameter adapted to engage a base aperture 125. The coupling 128 is optionally fused to the base of an injector or formed as a collet. Forms of accommodating different diameter injectors other than resizing an aperture are detailed with greater specificity with regard to FIG. 45.

A number of injectors greater than one or two injectors, as depicted for visual clarity in the figures, are readily accommodated through the provision of additional apertures formed within a liner base along with the provision of additional hardware and fittings to accommodate fluid communication with the additional injector. An aperture in a base-plate not coupled to an injector is sealed with a plug (not shown) formed of quartz or other material suitable for the reaction process occurring within an inventive liner.

Additional control over a given reaction process performed on a wafer batch occurs through the exchange of inventive liners that vary in attributes such as the inclusion of one or more bulging sections with each bulging section accommodating one or more injectors, the number of vertical courses of exhaust ports or slots, the angular relationship between a first injector and a vertical course of exhaust ports or slots in the liner, the vertical course being composed of exhaust ports, exhaust slots, or a combination thereof; vertical height and spacing between vertically displaced exhaust ports, and the total number of injectors.

The injectors 116, 215 and the liners 120 or 181 can be separate components, or the injector can be integrally formed with liner as a single piece. The latter embodiment is particularly useful in applications where it is desirable to frequently change the process chamber 102 configuration.

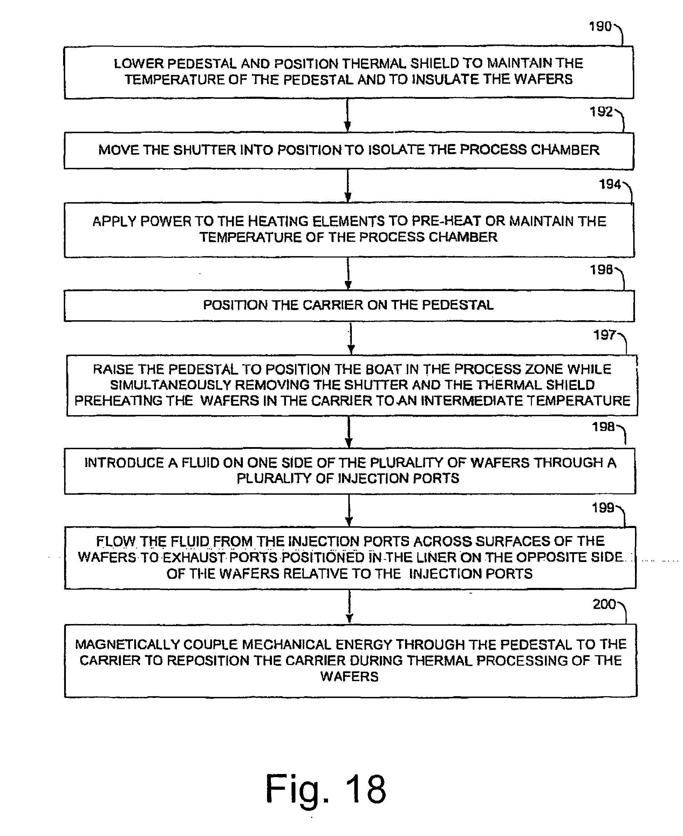

An illustrative method or process for operating the thermal processing apparatus 100 or 100' or 100" is described with reference to FIG. 18. FIG. 18 is a flowchart showing steps of a method for thermally processing a batch of wafers 108 wherein each wafer of the batch of wafers is quickly and uniformly heated to the desired temperature. In the method, the pedestal 130 is lowered, and the thermal shield 142 is moved into a position while the pedestal 130 is lowered to reflect heat from the bottom heating element 112-1 back to the pedestal 130 to maintain the temperature thereof, and to insulate the finished wafers 108 (step 190). Optionally, the shutter 158 is moved into position to seal or isolate the process chamber 102 (step 92), and the power is applied to the heating elements 112-2, 112-3, to begin preheating the process chamber 102 to or maintain at an intermediate or idling temperature (step 194). A carrier or boat 106 loaded with new wafers 108 is positioned on the pedestal 130 (step 196). The pedestal 130 is raised to position the boat in the process zone 128, while simultaneously removing the shutter 158, the thermal shield 146, and ramping up the bottom heating element 112-1 to preheat the wafers to an intermediate temperature (step 197). Preferably, the thermal shield 146 is removed just before the boat 106 is positioned in the process zone 128. A fluid, such as a process gas or vapor, is introduced on one side of the wafers 108 through a plurality of injection ports 180 (step 198). The fluid flows from the injection ports 180 across surfaces of the wafers 108 to exhaust ports 182 positioned in the liner 120 on the opposite side of the wafers relative to the injection ports (step 199). Optionally, the boat 106 can be rotated within the process zone 128 during thermal processing of the batch of wafers 108 to further enhance uniformity of the thermal processing, by magnetically coupling mechanical energy through the pedestal 130 to the carrier or boat 106 to reposition it during thermal processing of the wafers (step 200).

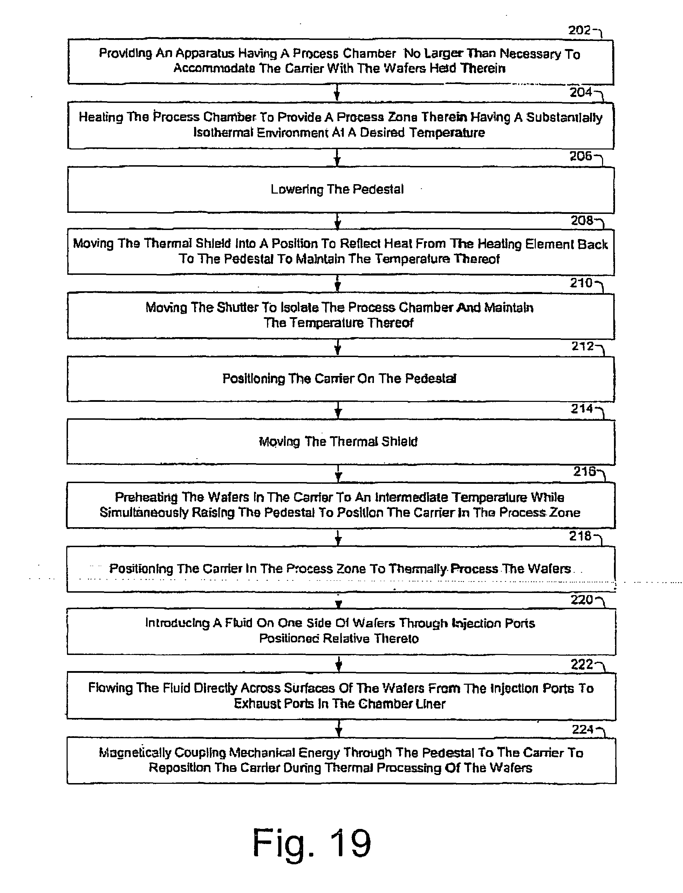

A method or process for a thermal processing apparatus 100 according to another embodiment will now be described with reference to FIG. 19. FIG. 19 is a flowchart showing steps of an embodiment of a method for thermally processing a batch of wafers 108 in a carrier. In the method, an apparatus 100 is provided having a process chamber 102 with dimensions and a volume not substantially larger than necessary (guard heaters absent) to accommodate the carrier 106 with the wafers 108 held therein (step 202). The pedestal 103 is lowered, and the boat 106 with the wafers 108 held therein positioned thereon (step 202). The pedestal 130 is raised to insert the boat in the process chamber 102, while simultaneously preheating the wafers 108 to an intermediate temperature (step 204). Power is applied to the heating elements 112-1, 112-2, 112-3, each disposed proximate to at least one of the top wall 134, the side wall 136 and the bottom wall 138 of the process chamber 102 to begin heating the process chamber (step 206). Optionally, power to at least one of the heating elements is adjusted independently to provide a substantially isothermal environment at a desired temperature in a process zone 128 in the processing chamber 102 (step 208). When the wafers 108 have been thermally processed, and while maintaining the desired temperature in the process zone 128, the pedestal 130 is lowered, and the thermal shield 142 is moved into position to insulate the finished wafers 108 and to reflect heat from the bottom heating element 112-1 back to the pedestal 130 to maintain the temperature thereof (step 210). Also, optionally, the shutter 158 is moved into position to seal or isolate the process chamber 102, and power applied to the heating elements 112-2, 112-3, to maintain the temperature of the process chamber (step 212). The boat 106 is then removed from the pedestal 130 (step 214), and another boat loaded with a new batch of wafers to be processed positioned on the pedestal (step 216). The shutter 158 is repositioned or removed (step 218), and the thermal shield withdrawn or repositioned to preheat the wafers 108 in the boat 106 to an intermediate temperature while simultaneously raising the pedestal 130 to insert the boat into the process chamber 102 to thermally process the new batch of wafers (step 220).

Stepped liners are typically used in traditional up-flow vertical furnaces to increase process gas velocities and diffusion control. They are also used as an aid to improve within-wafer uniformity. Unfortunately, stepped liners do not correct down- the-stack-depletion problems, which occur due to single injection point of reactant gases forcing all injected gases to flow past all surfaces down the stack. In prior art furnaces, the down-the-stack-depletion problem is solved. However, a flow path of least resistance may be created in the gap region between the wafer carrier and the liner inner wall instead of between the wafers. This least resistance path may cause vortices or stagnation which are detrimental to manufacturing processes. Vortices and stagnation in a furnace may create across wafer non-uniformity problems for some process chemistries.

The present invention provides an across-flow liner that significantly improves the within-wafer uniformity by providing uniform gas flow across the surface of each substrate supported in a carrier. In general, the across-flow liner of the present invention includes a longitudinal bulging section to accommodate an across-flow injection system so that the liner can be patterned and sized to conform to the wafer carrier. The gap between the liner and the wafer carrier is significantly reduced, and as a result, vortices and stagnation as occurred in prior art furnaces can be reduced or avoided.

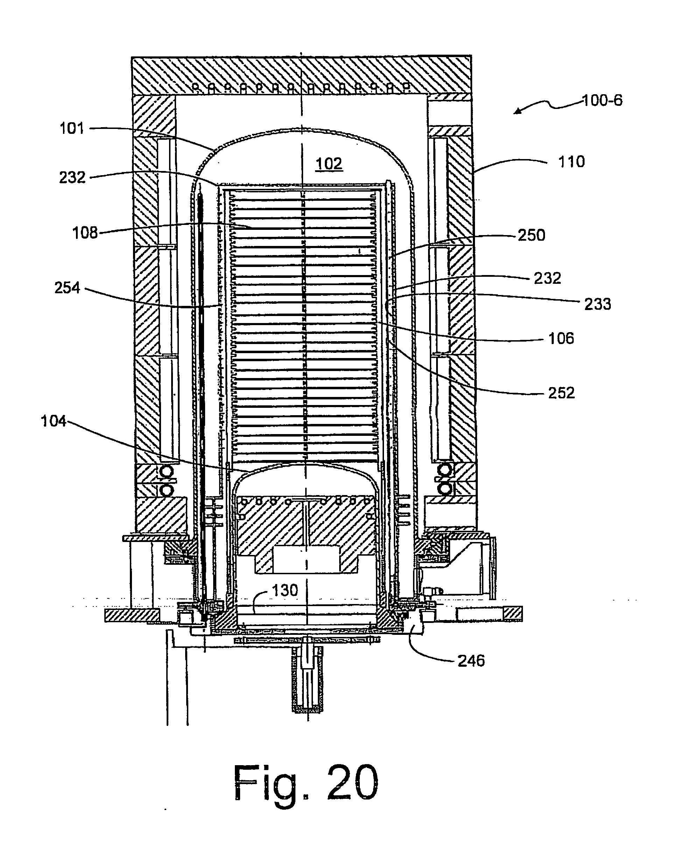

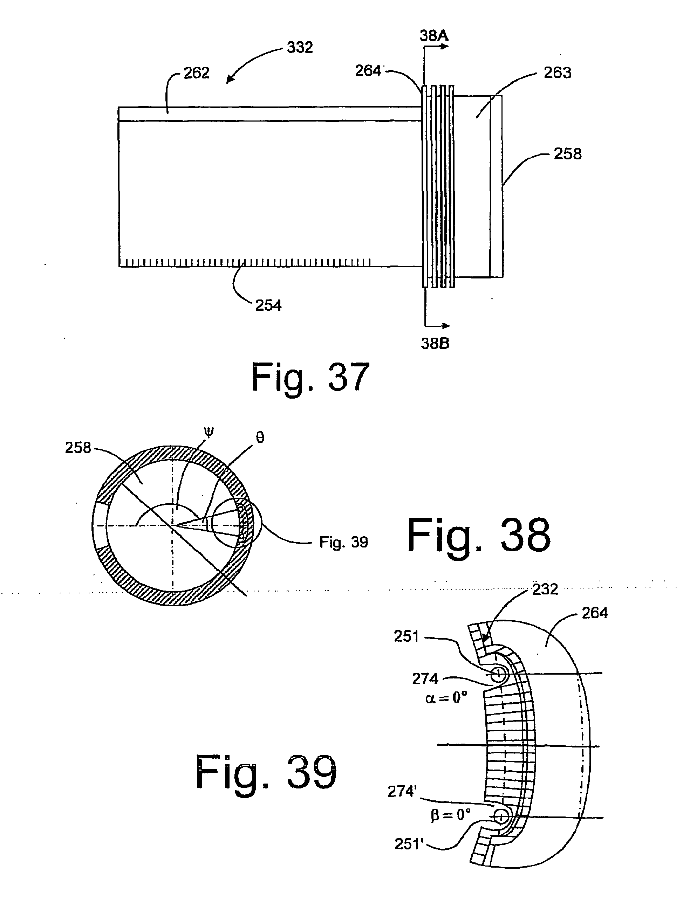

FIG. 20 shows a thermal processing apparatus 100-6 where like reference numerals correspond to those used with respect to the preceding figures and includes an across-flow liner 232 according to one embodiment of the present invention. To simplify description of the invention, elements not closely relevant to the invention are not indicated in the drawing and described. In general, the apparatus 100-6 includes a vessel 101 that forms a process chamber 102 having a support 104 adapted for receiving a wafer boat or carrier 106 with a batch of wafers 108 held therein. The apparatus 100-6 includes a heat source or furnace 110 that heats the wafers 108 to the desired temperature for thermal processing. An across-flow liner 232 is provided to increase the concentration of processing gas or vapor near wafers 108 and reduce contamination of wafers 108 from flaking or peeling of deposits that can form on interior surfaces of the vessel 101. The liner 232 is patterned to conform to the contour of the wafer carrier 106 and sized to reduce the gap between the wafer carrier 106 and the liner wall 233 through the inclusion of a bulging section 262 adapted to accommodate one or more injectors 215. Multiple such bulging sections optionally are provided, each accommodating one or more injectors 215 or 251. Such a multiple bulging section liner is depicted in FIGS. 37-39 where FIG. 38 is a cross-sectional view along line 38A-38B of FIG. 37 and FIG. 39 is an expanded view of the bulging section region base with a movable pedestal 130. The liner 232 is mounted to a base plate 124 and forms a seal with a movable pedestal 130.

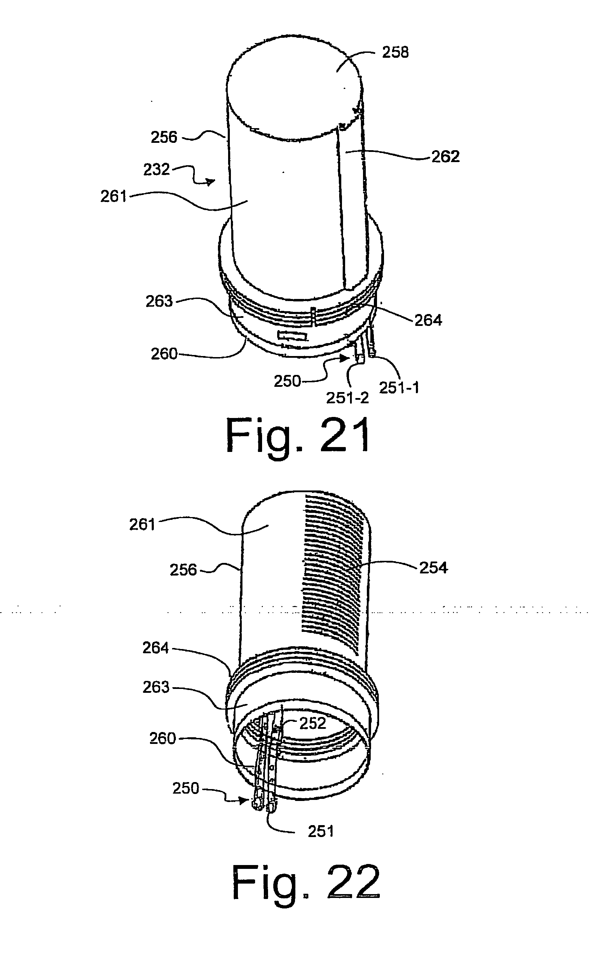

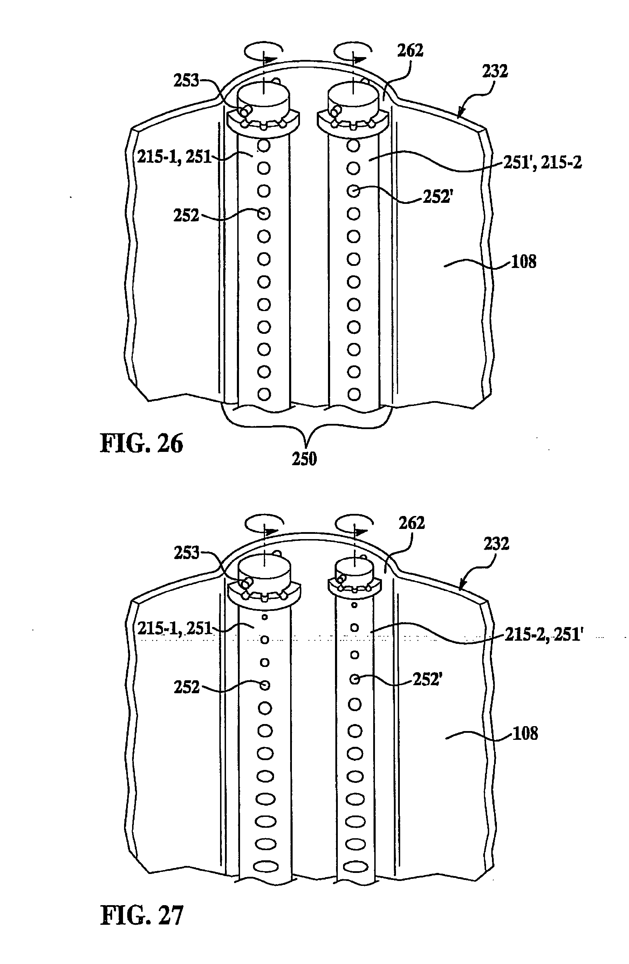

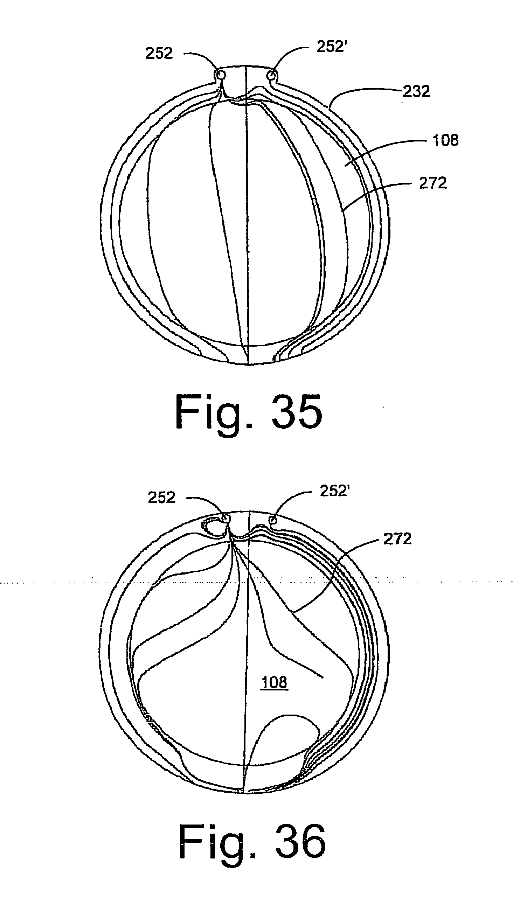

As shown with greater clarity in FIGS. 21 and 22, an across-flow injection system 250 is disposed within the long-bulging section 262 of the liner 232. The injection system 250 includes at least one injector 215-1 or 251. It is appreciated that in instances when multiple injectors are present, the inner diameter of each injector is independently selected. Gases are introduced into the liner volume through a plurality of injection orifices 181 or 252 from one side of the wafers 108 and carrier 106 and flow across the surface of the wafers in a laminar flow as described below. Preferably, the orifices 181 or 252 are aligned with the wafers 108 in the support positions of the carrier 106 so as to promote vertical wafer-to-wafer (WTW) gas flow uniformity and as a result WTW processing uniformity. As will be further detailed with respect to FIGS. 26 and 27, it is appreciated that the area and shape of a given orifice 181 or 252 are independent of those of adjacent orifices with a given injector 215-1 or 251. As shown in FIGS. 21, 22, and 28-30, a vertical course of a plurality of exhaust ports or slots 254 are formed in the liner 232 in a location approximately 180 degrees from the long-bulging section 262 and correspond to an angle ψ of 170 degrees. The size and pattern of the ports or slots 254 are predetermined and preferably cooperate with the spacing between and number of the injection orifices 181 or 252 to facilitate across-flow. It is appreciated that a second, third, or more vertical courses of exhaust ports or slots are cut into a liner wall 233 in a position other than the bulging section 262. While FIGS. 20-22 depict the vertical course of exhaust ports or slots 254 as uniform area rectilinear slots aligned with orifices and wafer substrates, the area and shape of an individual port or slot is independent of that of other ports or slots within the same course. Similarly, a liner 232 is readily formed having a vertical course of exhaust ports or slots 254 and a second course of exhaust ports or slots that are rectilinear slots of a different total area or shape such as circular, oval, parallelogram, or other geometric forms, as compared to the vertical course 254. Such variants in liner design are provided in FIGS. 36, 50, and 52.

The across-flow liner can be made of any metal, ceramic, crystalline or glass material that is capable of withstanding the thermal and mechanical stresses of high temperature and high vacuum operation, and which is resistant to erosion from gases and vapors used or released during processing. Preferably, the across-flow liner is made from an opaque, translucent or transparent quartz glass. In one embodiment, the liner is made from quartz that reduces or eliminates the conduction of heat away from the region or process zone in which the wafers are processed.

In general, the across-flow liner 232 includes a cylinder 256 having a closed end 258 and an open end 260. The cylinder 256 is provided with the longitudinal bulging section 262 to accommodate an across-flow injection system 250 inclusive of one or more injectors 215-1 or 251. Preferably, the bulging section 262 extends the substantial length of the cylinder 256.

The across-flow liner 232 is sized and patterned to conform to the contour of the wafer carrier 106 and the carrier support 104. In one embodiment, the liner 232 has a first section 261 sized to conform to the wafer carrier 106 and a second section 263 sized to conform to the carrier support 104. The diameter of the first section 261 may differ from the diameter of the second section 263, i.e., the liner 232 may be "stepped" to conform to the wafer carrier 106 and carrier support 108 respectively. In one embodiment, the first section 261 of the liner 232 has an inner diameter that constitutes about 104 to 110% of the wafer carrier 106 outer diameter. In another embodiment, the second section 263 of the liner 232 has an inner diameter that constitutes about 115 to 120% of the outer diameter of the carrier support 108. The second section 263 may be provided with one or more heat shields 264 to protect seals such as o-rings from being overheated by heating elements.

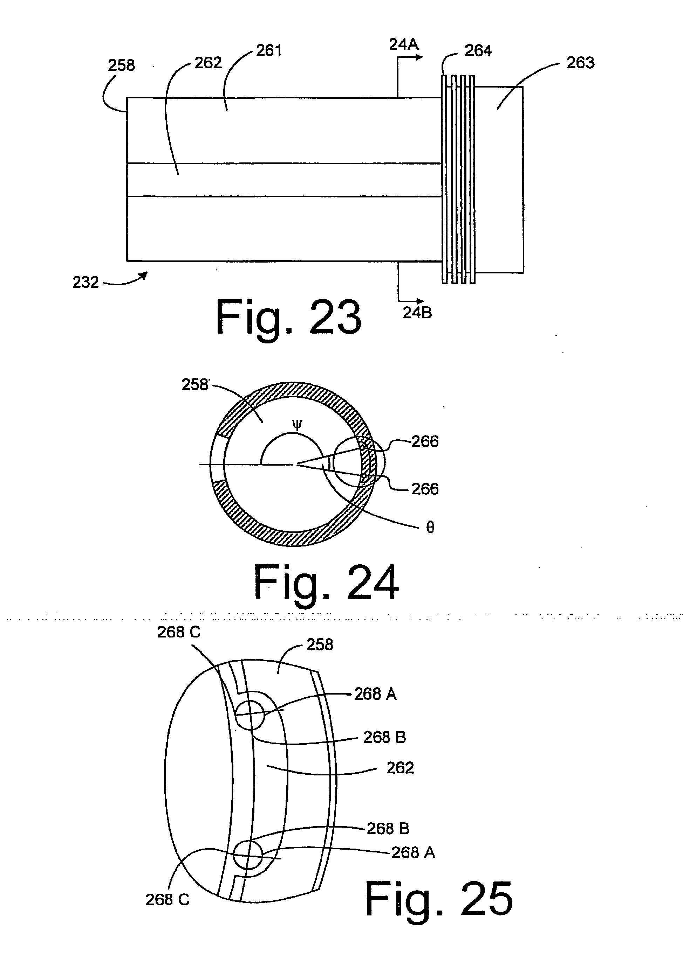

FIG. 23 is a side view of the across-flow liner 232. The longitudinal bulging section 262 extends the length of the first section 261. The injection system 250 is accommodated in the bulging section 262 and introduces one or more gases into the across-flow liner 232 between the wafers 108 spaced along the height of a carrier 106. One or more heat shields 264 is optionally provided in the second section 263.

FIG. 24 is a cross-sectional view of the across-flow liner 232 showing the open end 263 of the cylinder 256 surrounding openings 266 in a base plate 124 for receiving the across-flow injection system 250. The injection system 250 has at least one injection tube 215-1 or 251 (described in detail below) to fit within the openings 266. As shown in detail in FIG. 25, the openings 266 in the base plate 124 have notches 268 for orienting and stabilizing an across-flow injection system. Although three notches (268A, 268b, 268C) are shown in the openings 266 for illustrative purpose, it should be noted that any number of notches can be formed so that the injection tube can be oriented to any direction up to and including 360 degrees relative to the across-flow liner 232 and to each other. In addition to the notched opening-index pin rotational angle α adjustment, it is appreciated that other techniques for securing an injector in a selected rotational angle α relative to the wafer center illustratively include a circumferential clamping ring, a key simultaneously engaging an injector and a liner base, and a friction fit.

Referring to FIG. 26, the across-flow injection system 250 comprises one or more elongated tubes 215-1 or 251 rotatable about an axis perpendicular to the desired processing surfaces of the wafers. PCT/US04/031063 describes one embodiment of an injection system, the disclosure of which is hereby incorporated by reference in its entirety. In the preferred embodiment, the elongated tubes 251 are provided with a plurality of injection orifices 252 longitudinally distributed along the length of the tubes for directing reactant and other gases across the surface of each substrate. The injection orifices 252 have the same area and shape as the adjacent orifices. A second injector 252' is shown having the same inner diameter as injector 252 with like orifices 252. Each injector 251 and 251' is independently rotatable about the injector long axis. Preferably, as shown in FIG. 26, the orifices 252 of injector 251 and the orifice 252' of injector 251' are aligned to coincide with a wafer placed on a carrier so as to facilitate WTW uniformity while batch processing. Alternatively, as shown in FIG. 27, the diameter of injectors 251 and 251' are different. An instance where varied diameter injectors 251 and 251' are particularly advantageous is where two gases are desired to be provided in an across-flow path over a wafer surface at similar injector pressures although at different delivery volumes. Regardless of the relative diameters of injectors 251 and 251', the area and shape of the orifices 252 and 252' are optionally varied along the injector length. It has been discovered that the vertical decrease in injector emission pressure is compensated for by increasing the area of orifices upward along the length of the injector (FIGS. 26 and 27 are inverted perspective views). In order to increase orifice area while maintaining registry with orifices of other injectors, circular orifices are optionally formed in a shape illustratively including rectilinear, oval, or combinations thereof. Preferably, the orifices are in alignment with a wafer substrate to provide across-flow.

As shown in FIGS. 26 and 27, the elongated injector 251 includes an index pin 253 for locking the elongated tube in one of the notches 268 in the openings 266, and the injection ports or orifices 252 are formed in line with the index pin. Therefore, when the elongated tube is installed, the index pin can be locked in one of the notches 268 and the injection ports 252 are oriented in a direction as indicated by the appropriate notch 268. An indicator located on the opposite end of tubes 251 further allows a user to adjust the location of the injection ports 252. This adjustment is performed before, during and after a thermal processing run without removal of the across-flow liner 232 from the vessel.

The bulging section 262 of the across-flow liner 232 accommodates the across-flow injection system 250 therein and the liner 232 is made conformal to the contour of the wafer carrier. This confirming of the liner 232 to the wafer carrier reduces the gap between the liner and the wafer carrier, thereby reducing the vortices and stagnation in the gap regions between the liner inner wall and the wafer carrier 106, improving gas flow uniformity and the quality, uniformity, and repeatability of the deposited film. It is appreciated that multiple bulging sections are employed around the periphery of an inventive liner, with each bulging section adapted to receive one or more injectors.

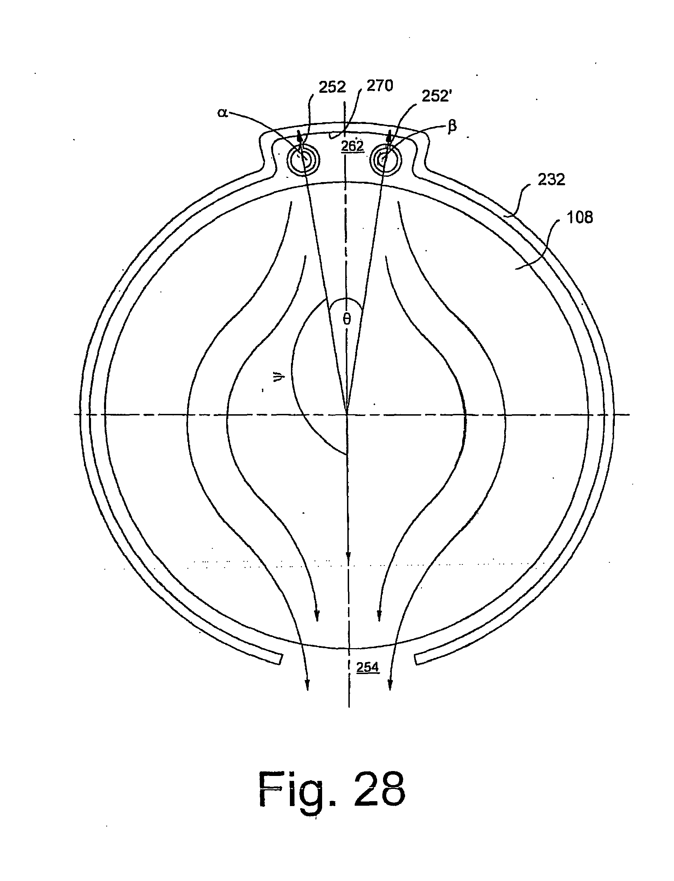

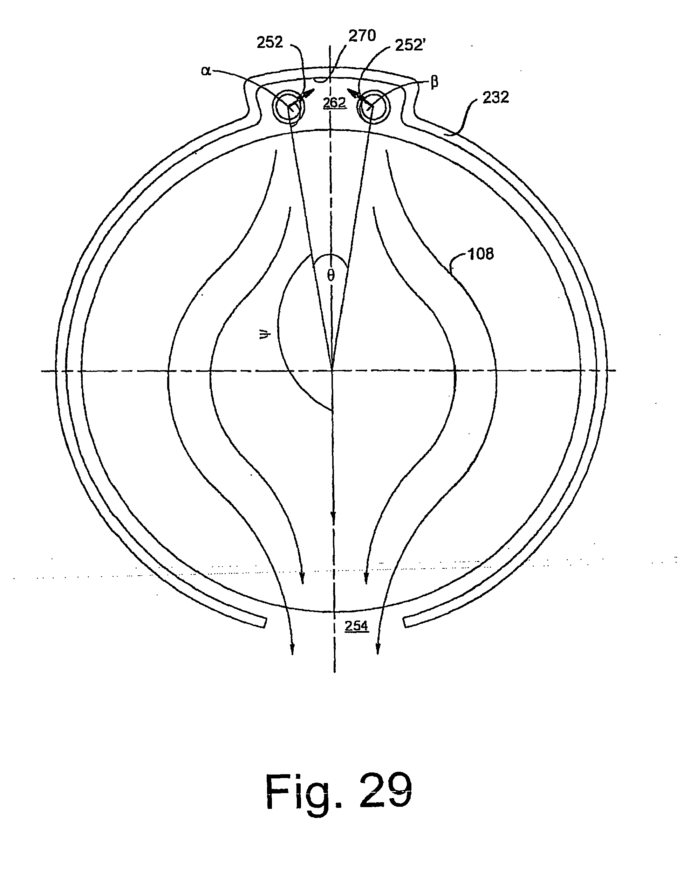

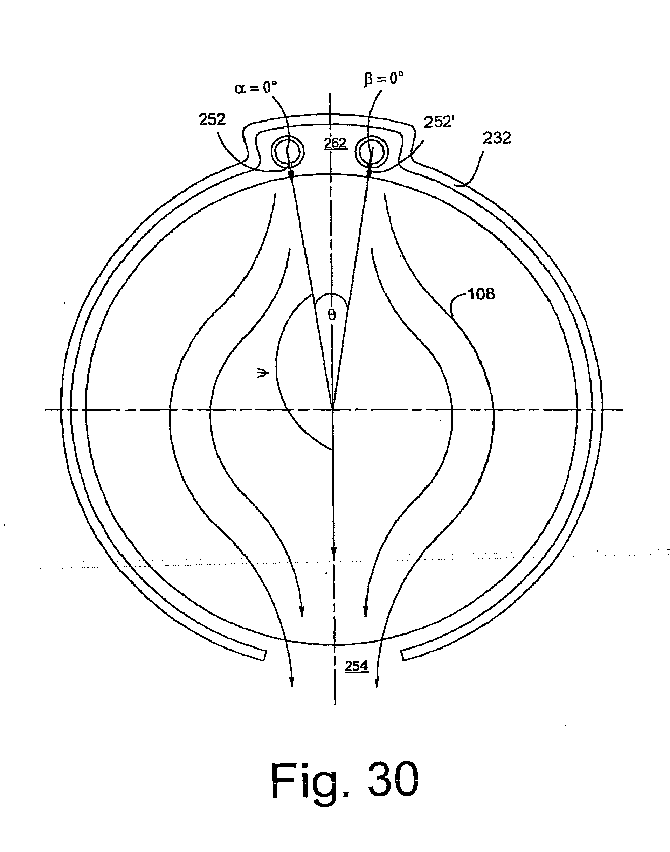

For example, the index pin 253 the elongated injector 251 can be received in notch 268A so that the injection orifices 252 are oriented to face the inner surface of the liner 232 and define an angle α of 180 degrees, as indicated in FIG. 28. At this angle α and a corresponding 180 degree angle β for injector 251', gases exiting the injection orifices 252 and 252' impinge the liner wall 270 and mix in the bulging section 262 prior to flowing across the surface of each wafer substrate 108. In another orientation shown in FIG. 29, the index pin in the elongated tube is received in notch 268B so that the injection orifices 252 and 252' are oriented to face each other. In this orientation, gases exiting the injection ports 252 and 252' impinge each other and mix in the bulging section 262 prior to flowing across the surface of the wafer substrate 108. In another orientation shown in FIG. 30, the index pin in the elongated injector is received in notch 268C so that the injection ports 252 and 252' are oriented to face the center of the wafer substrate 108 and angles α and β of 0 degrees to directly flow across the wafer substrate 108. The angles α and β are readily determined based on variation within a single wafer surface topography associated with factors illustratively including gas molecular weight, reaction activation energy, operating temperature, flow rate of a gas, and operating pressure. While FIGS. 28-30 depict both injectors 251 and 251' rotated to equal values of α and β, it is appreciated that each inventive injector is rotated independently to afford instances where angles α and β are unequal.

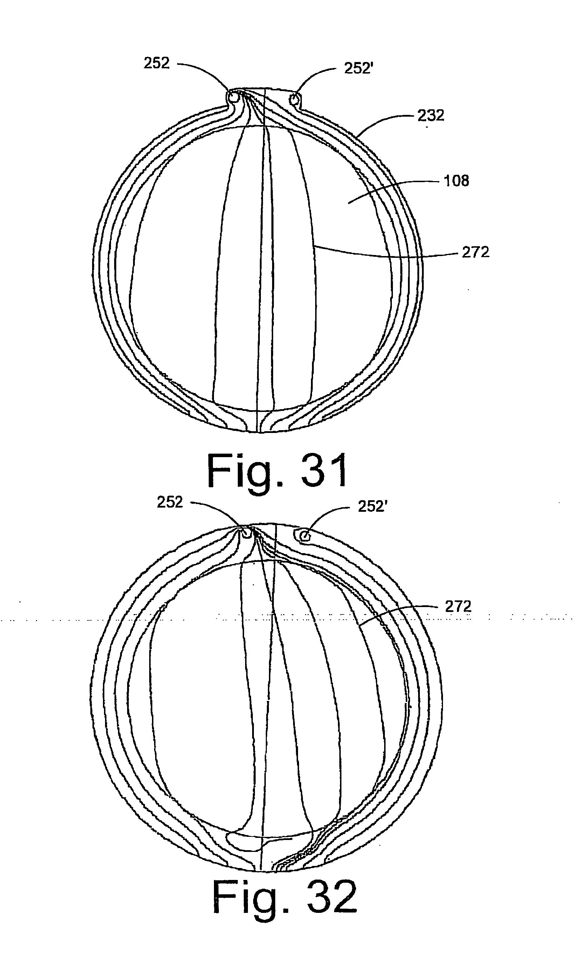

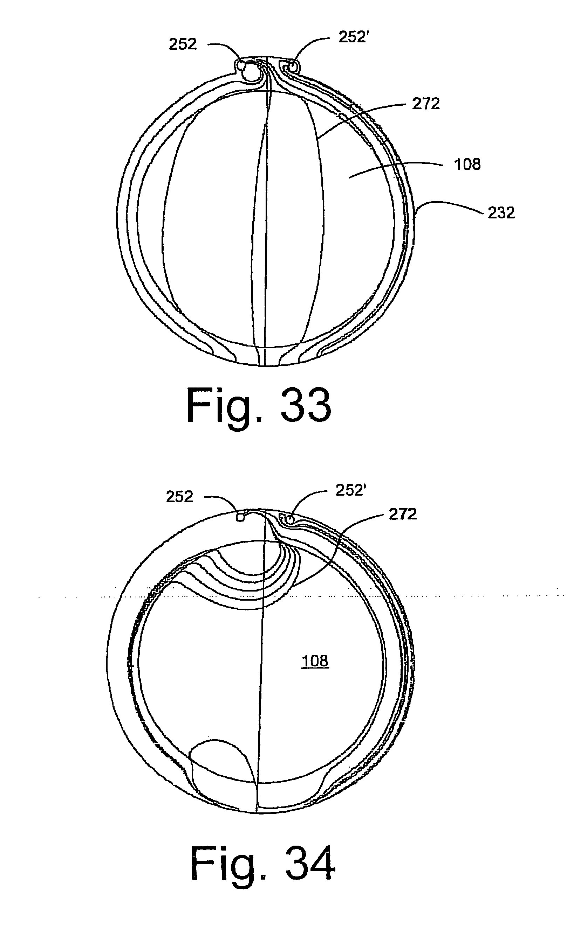

FIGS. 31-36 are particle trace graphics representing gas flow lines across the surface of a wafer substrate inside a liner of FIGS. 20-25 relative to the like liner lacking a bulging section with the same angles α, β, θ, and ψ. The graphics show particle traces 272 from injector ports to an exhaust slot in highly imbalanced flow conditions. The flow momentum out of the first (leftmost) injector orifice 252' is ten times greater than the second (rightmost) injector orifice 252. As demonstrated in FIGS. 31, 33 and 35, the across-flow liner of the present invention has a bulging section which promotes uniform gas flows across the surface of a substrate as compared with a circularly symmetrical analog inventive liner. The bulging section in the inventive across-flow liner provides a mixing chamber for the gases exiting the injection orifices prior to flowing across the wafer surface for α>0 degrees and thus facilitates momentum transfer of "ballistic mixing" of gases. In contrast, a liner lacking the bulging section affords a gas flow across the surface of a wafer substrate that is less regular under like conditions, as shown in FIGS. 32, 34 and 36, but nonetheless may be suitable for many reaction schemes.

Referring now to FIGS. 37-39, an inventive liner is depicted generally at 332 where like numerals used with respect to FIGS. 37-39 correspond to those detailed with respect to FIGS. 23-25. The liner 332 has at least two openings to in an underlying base plate to receive at least two injectors 251 and 251', each in a buliging section 274 and 274', respectively. It is appreciated that the dimensions of opening 274' are readily varied relative to 274 to accommodate a second injector 251' having an outer diameter injector that varies from that of the injector 251 sized to be accommodated within opening 274, as for instance depicted in FIG. 27. The openings 274 and 274' extend the length of the bulging section 262 so as to accommodate the full height of the injector and isolate each injector 251 and 251' where like numerals correspond to those used with respect to preceding figures. It is appreciated that while FIGS. 38 and 39 depict two injectors, 251 and 251', each retained within an individual bulging section 274 and 274', and defining an angle relative to a wafer center, a third or more injectors are readily accommodated within individual bulging sections within a liner 332. Additionally, it is appreciated that the angle θ, defined as the angle between injector 251 and 251' relative to a wafer center, is also readily varied beyond the 15 degrees depicted in FIG. 38.

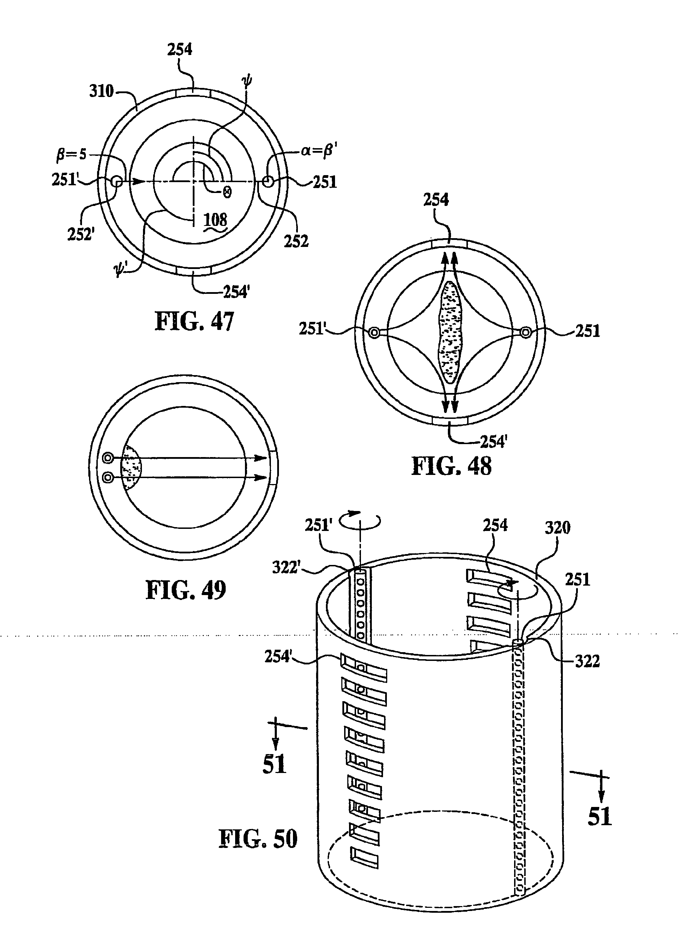

As further detailed with respect to FIGS. 46, 47, 50 and 51, the angle θ typically is varied between 5 and 310 degrees. In the instance where θ is between 100 and 140 degrees a particularly efficient flow pattern is formed with a single course of exhaust ports or slots spaced at an angle ψ of between 100 and 140 degrees. In the instance where θ is between 150 and 210 degrees, a particularly efficient flow pattern is formed with a two courses of exhaust ports or slots spaced at an angle ψ of between 80 and 100 and ψ' of between 260 and 280 (-80 and -100) degrees, so as to intersperse injectors and exhaust courses as depcited in FIGS 46 or 50. Preferably, θ is between 170 and 190 degrees. Likewise, the angle ψ defined as the nearest angle through the wafer center between the first injector 251 and the angularly closest vertically extended course of exhaust ports or slots. While the angle ψ of 165 degrees is depicted in FIG. 38, the angle ψ is readily varied according to the present invention between 30 and 270 degrees, as further detailed with respect to FIGS. 47, and 50-53. It is appreciated that an additional course of exhaust ports or slots are optionally formed in the inventive liner that are rectilinear slots of a different total area; or different shape such as circular, oval, parallelogram, or other geometric forms, as compared to the vertical course 254.

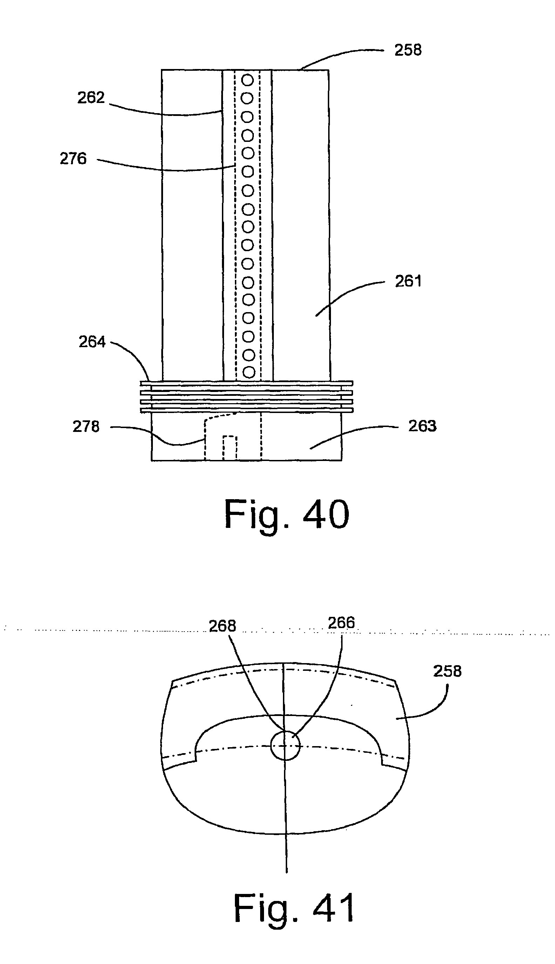

FIGS. 40-41 depict a liner 232 accommodating an h-tube orificed injector in the bulging section 262 where like numerals correspond to those detailed with respect to FIGS. 20-30. An h-tube 278 is connected to the elongated injector 276 in the second section 263 of the liner 232. Two gases are introduced into the elongated tube 276 and h-tube 278, respectively, and are premixed in the elongated tube 276 prior to exiting the injection orifices 252.

In operation, a vacuum system produces a reduced pressure in a reaction chamber 102. The reduced pressure acts in the vertical direction of the vessel 101. The across-flow liner 181 or 232 is operative in response to the reduced pressure to create a partial pressure inside the across-flow liner. The partial pressure acts in a horizontal direction and across the surface of each wafer substrate 108. A gas stream is introduced via each of the orificed injectors 215-1 or 251 present with the understanding that two or more such injectors are present. If multiple injectors are present, the injectors are separated by an angle θ of between 5 and 310 degrees with the option to adjust angles α and β independently. The gases emitted from the orifices 180 or 252 exit on one side of the wafer 108 and pass as laminar flow across the wafer 108 to the ports or slots 121 or 254 and between two adjacent wafers 108 supported by a wafer carrier 106. The first exhaust ports or slots are separated from the first injector by an angle ψ of between 30 and 270 degrees.

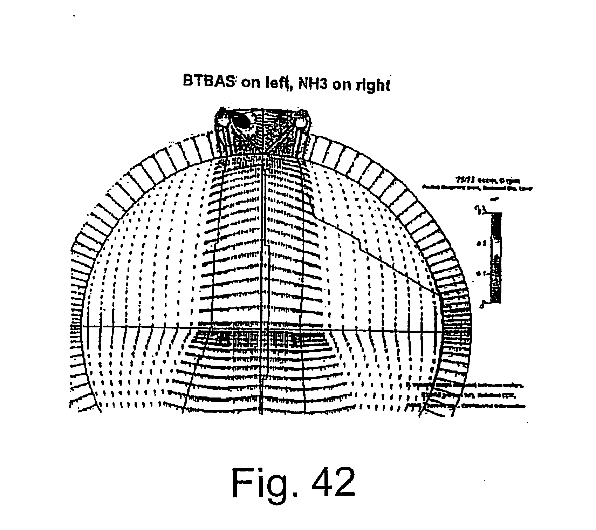

FIG. 42 is Computational Fluid Dynamics (CFD) demonstration for a thermal processing apparatus including a cross-flow liner of FIG. 28 in which the gases introduced into the two injection tubes were BTBAS (bis tertbutylamino silane) and NH3 respectively at 75 sccm.

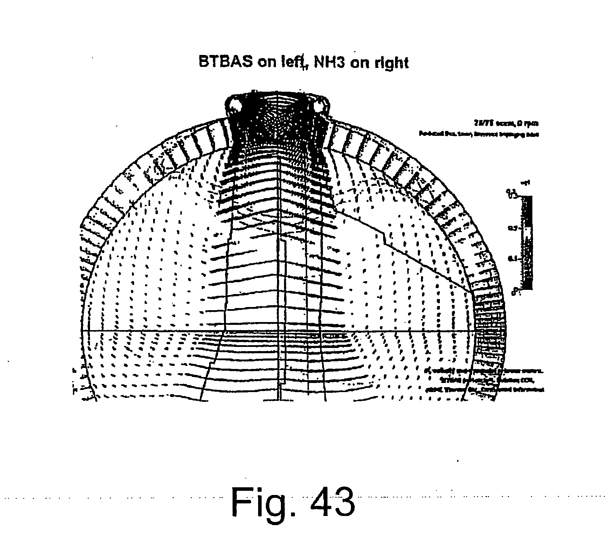

FIG. 43 is Computational Fluid Dynamics (CFD) demonstration for a thermal processing apparatus including a cross-flow liner of FIG. 29 in which the gases introduced into the two injection tubes were BTBAS (bis tertbutylamino silane) and NH3 respectively at 75 sccm.

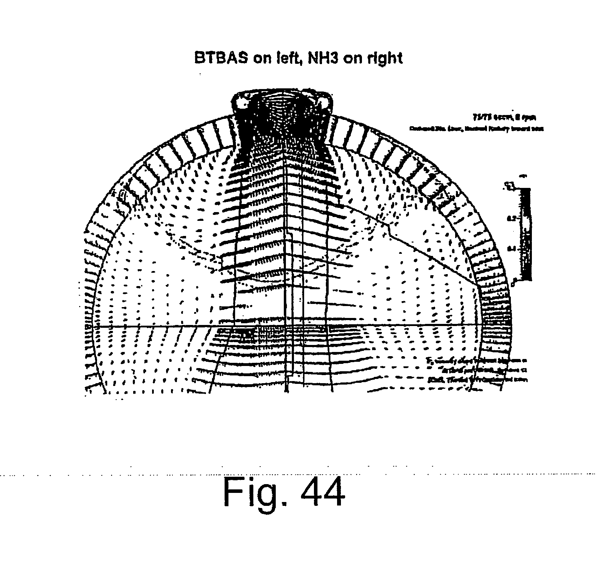

FIG. 44 is Computational Fluid Dynamics (CFD) demonstration for a thermal processing apparatus including a cross-flow liner of FIG. 30 in which the gases introduced into the two injection tubes were BTBAS (bis tertbutylamino silane) and NH3 respectively at 75 sccm. FIG. 44 demonstrates a good cross-wafer velocity.

To further illustrate the breadth of the present invention, reference is made to FIGS. 46 and 47 that depict a perspective cross-sectional view in FIG. 46 and a cross-sectional view downward from plane FIG. 47 in FIG. 46 of an inventive liner 310 where like numerals and angles are those used with reference to the aforementioned figures. The liner 310 has a first injector 251 and a second injector 251' defining an angle θ of 180 degrees. It is appreciated that in the various liner constructs according to the present invention, the angle θ is readily varied between 5 and 310 degrees. The liner 310 also has two opposing vertical courses of exhaust ports or slots 254 and 254' defining angles relative to first injector 251 of ψ equal to 90 degrees and ψ' equal to 270 (-90) degrees. Preferably, while the orifices 252' are aligned with corresponding orifice 252, as well as a wafer substrate 108, it is appreciated that an exhaust port or slot dimensions, alignment, and shape are less critical promoting wafer-to-wafer and within-wafer conformal treatment. As such, vertical courses of exhaust ports or slots 254 and 254' depicted in FIG. 47 increase in area upward along the course, while the height of a given exhaust port 254 or 254' is sufficiently large to extend over a height encompassing from one to five wafer substrates 108 is positioned on a wafer carrier residing within the liner 310. The vertical exhaust port or slot courses 254 and 254' optionally vary in dimension or shape in a given plane along the vertical extent of the liner 310. While the orifice angle relative to the wafer center for injector 251 is at an angle α of 3 degrees and injector orifices 252 define an angle β of 5 degrees, it is appreciated that each of the angles α and β are independently modified to any angular value of between 0 and 360 degrees. Factors relevant in determining angles α and β as well as the ability to test the resultant flow patterns through computational flow dynamics have been previously detailed herein.

The counter across-flow configuration for a liner depicted in FIGS. 46 and 47 is particularly advantageous with the use of a highly reactive chemical species for the deposition of a material on wafer substrates. Representative of these highly reactive species are radicals such as oxygen, hydroxyl, hydrogen, and nitrogen radicals. Exemplary chemistries using radicals include the growth of an oxide from the wafer material through exposure to oxygen and/or hydroxyl radicals. Similarly, nitrogen radicals are used to incorporate nitrogen into oxide films such as silicon oxides and high K oxides in order to improve various physical and/or electrical properties of the resultant oxide film. Hydrogen or deuterium radicals are routinely used to anneal or otherwise treat copper films. Owing to the highly reactive nature of such chemical species, requirements to provide a uniform flow of reactants across a wafer substrate prior to mixing reacting with another species reactive with the first reactive species are necessary to maintain within-wafer uniformity. The alternative to the provision of a uniform reactant flow across a wafer surface is reagent depletion at the far extent of the wafer substrate which for a stationary substrate is the far edge and for a rotating substrate is the central region.

FIG. 48 is a schematic summarizing computational fluid dynamic simulations where a reactor including the linear 310 of FIGS. 46 and 47 at a total pressure of 3 torr at 750° with oxygen emitted from injector 251 and hydrogen emitted from reactor 251' at a flow rate of 1:1 slm and a gap between the wafer substrate and injector orifices of 9.5 millimeters. The shaded central region indicates the location of high reaction rates and film deposition between hydrogen and oxygen emitted from the injectors 251 and 251'. The comparative zone of high hydrogen and oxygen reaction rate for the reactor configuration depicted in FIG. 36 is shown in FIG. 49 where a pronounced edge effect is observed resulting in a comparatively depleted reaction zone in the central region of the wafer substrate.

While FIGS. 46 and 47 depict for visual clarity two injectors and two vertical courses of exhaust ports or slots, it is appreciated that the number of injectors used is readily varied from one to ten to adjust reaction rates in specific wafer substrate regions. Spacing of injectors in the aforementioned embodiments can be uniform about the periphery of a liner or optionally a non-uniform distribution of injectors is provided. Likewise, the number of vertical courses of exhaust ports or slots is readily varied from one to ten with the area of exhaust ports or slots in a given horizontal plane being uniform or non-uniform. Additionally, the shape, area, and height of exhaust ports or slots is readily varied within a single vertical course or between vertical courses.

Another particularly preferred reactor configuration has a single course of exhaust ports or slots defining an angle ψ of 120 degrees relative to injector 251. The injector 251 defines an angle θ of 120 degrees to a second injector 251 with an optional third injector located intermediate between first injector 251 and the second injector 251' and preferably at a position of θ/2. In the instance where injector 251 is flowing a first highly reactive species and the injector 251' is flowing a second highly reactive reactant, the third injector intermediate therebetween preferably flows an inert gas at a rate selected to adjust the characteristics of the high reaction region.

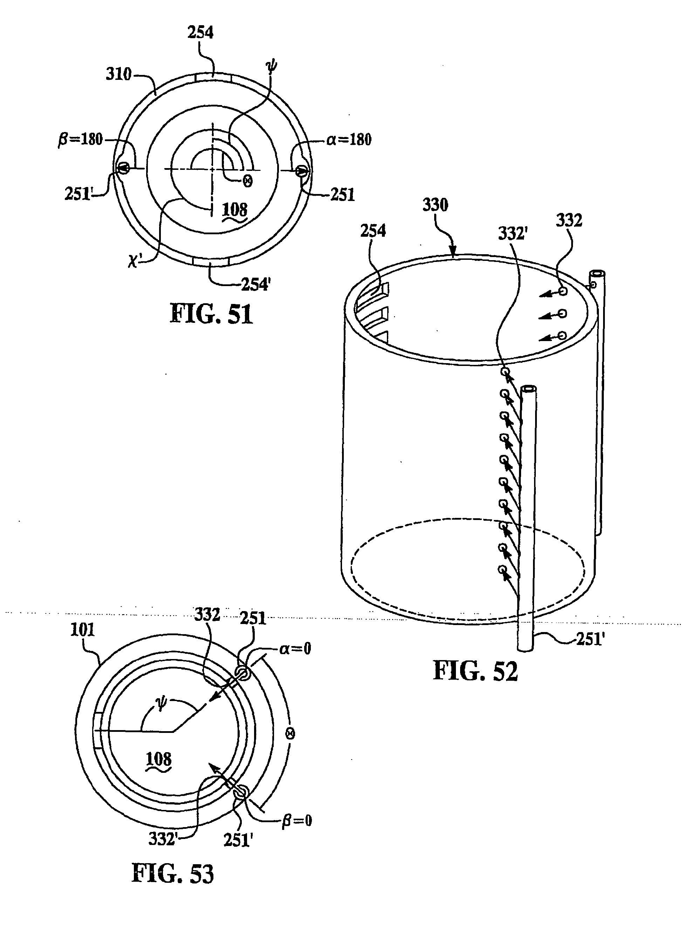

FIGS. 50 and 51 depict a liner 320 similar to that depicted with respect to FIGS. 46 and 47 with the exception of bulging sections 322 and 322' being provided for respective injectors 251 and 251'. Like numerals used with respect to FIGS. 50 and 51 correspond to those used with respect to the preceding figures. The plane FIG. 51 shown in FIG. 50 shows the cross section through which FIG. 51 is provided. With the incorporation of bulging sections 332 and 332', in concert with the optional rotation of injectors 251 and 251', orifice introduced gases are reflected off the interior of the bulging sections to broaden the flow front of the reactive species and further shape and refine the zone of high reactivity and deposition relative to that provided in FIG. 46 for a reactor inclusive of a liner 310. As with preceding versions of an inventive liner and injector system, injector dimension, orifice sizing, exhaust port or slot shape, area, and type are all variable as well as angles α, β, θ, ψ, and ψ'. Additionally, it is appreciated that from one to ten injectors are present in a given liner as well as from one to ten vertical courses of exhaust ports or slots.

FIGS. 52 and 53 depict a liner and vertical injector system particularly well suited for instances where small tolerances are desired between a wafer edge and a surrounding liner, where like numerals correspond to those used with respect to the previous figures. A liner 330 is provided with at least one vertical course of exhaust slots or ports 254. At least one vertical course of inlet ports or slots 332 is formed in the liner 330. The size and shape of each inlet port or slot is independent to that of adjacent ports or slots. Preferably, each inlet port or slot is aligned with a wafer substrate supported on the wafer carrier 106 (not shown). The vertical course of exhaust ports or slots 254 is likewise aligned with a wafer substrate 108 to form a true across-flow or alternatively the vertical course of exhaust ports or slots 254 have a height that encompasses the vertical extent of from one to five wafer substrates mounted on a wafer carrier. Preferably, the exhaust ports or slots are aligned with the orifices 332 and 332'. Optionally, the area of the exhaust ports or slots increases upwardly along the liner 330 as shown in FIG. 53. Proximal to and in fluid communication with the inlet ports or slots 332 and 332' are complementary injectors 251 and 251'. As a result, emission from orifice 252 of injector 251 is fed through the liner 330 via an inlet port or slot in proximity to a wafer substrate 108. A vessel 101 encompasses injectors 251 and 251' as well as the liner 330, contained within vessel 101 as shown in FIG. 54 and omitted from FIG. 53 for visual clarity. As a result of reducing the gap between liner 332 and the edge of a wafer substrate 108, turbulence associated with optional wafer rotation is diminished. Angles α, β, θ, and ψ as depicted in FIGS. 53 and 54 are 0, 0, 120, and 120 degrees, respectively. It is appreciated that these angles are readily varied to accommodate particular reactions or thermal processing conditions.

The foregoing description of specific embodiments and examples of the invention have been presented for the purpose of illustration and description, and although the invention has been described and illustrated by the preceding examples, it is not to be construed as being limited thereby. They are not intended to be exhaustive or to limit the invention to the precise forms disclosed, and many modifications, improvements and variations within the scope of the invention are possible in light of the above teaching. It is intended that the scope of the invention encompass the generic area as herein disclosed, and by the claims appended hereto and their equivalents.

## Claims

1. An across-flow liner comprising:
a cylinder having a sealed end and an open end, the open end adapted to receive a batch wafer carrier having a plurality of wafer support positions therethrough, said cylinder having a plurality of vertically displaced exhaust ports or slots; and
a first injector having a first series of axially aligned orifices, a first injector height and defining a first vertical axis, said first injector coupled to a first fluid supply and each of said first series of axially aligned orifices is in alignment with one of said plurality of wafer support positions.

2. The liner of claim 1 further comprising a second injector having a second series of axially aligned orifices, a second injector height and defining a second vertical axis, said second injector coupled to a second fluid supply such that each of said second series of axially aligned orifices is in alignment with one of said plurality of wafer support positions.

3. The liner of claim 2 wherein said first injector and said second injector are displaced around said cylinder to define an angle θ relative to a wafer in one of said plurality of wafer support positions, wherein θ is between 5 and 310 degrees.

4. The liner of claim 3 wherein θ is between 100 and 140 degrees and said first injector defines an angle ψ through the center of the wafer substrate through the middle of one of said plurality of vertically displaced exhaust ports or slots where ψ is between 100 and 140 degrees.

5. The liner of claim 3 wherein θ is between 150 and 210 degrees and further comprising a second plurality of vertically displaced exhaust ports or apertures wherein said first injector defines an angle ψ through the center of the wafer substrate through said plurality of vertically displaced exhaust ports or slots where ψ is between 80 and 100 and said first injector defines an angle ψ' through said second plurality of vertically displaced exhaust ports or slots where ψ' is between 260 and 280 degrees.

6. The liner of claim 5 wherein the angle θ is between 170 and 190 degrees.

7. The liner of claim 5 wherein said first injector is located within a bulging section of said cylinder.

8. The liner of claim 2 wherein said cylinder has at least one bulging section and said first injector and said second injector are located in the at least one bulging section.

9. The liner of claim 8 wherein said first injector is located within a first bulging section and said second injector is located in a second bulging section of the at least one bulging section of said cylinder.

10. The liner of claim 8 wherein said first injector and said second injector are located within a unified bulging section of the at least one bulging section of said liner.

11. The liner of claim 1 wherein the first series of axially aligned orifices define an angle α through the first vertical axis relative to a center of a wafer substrate located in one of said plurality of wafer support positions, wherein α is more than 90 and less than 270 degrees.

12. The liner of claim 11 wherein the angle α is selectively adjustable.

13. The liner of claim 2 wherein said first injector has a first inner diameter and said second injector has a second injector inner diameter wherein the first injector inner diameter and the second injector inner diameter are unequal.

14. The liner of claim 1 wherein the first series of axially aligned orifices vary vertically along the injector height as to at least one of: orifice area and orifice shape.

15. The liner of claim 14 wherein orifice area increases along the first injector height and distal to said first fluid supply.

16. The liner of claim 1 wherein said plurality of vertically displaced exhaust ports or slots vary vertically in regard to at least one of: shape, area, and height.

17. The liner of claim 16 wherein at least one of said plurality of vertically displaced exhaust ports or slots has a height in registry with more than one of said plurality of wafer support positions.

18. The liner of claim 1 wherein said cylinder has a vertical course of inlet ports or slots and said first injector is located external to said cylinder so as to provide said first fluid supply into said cylinder by way of said first series of axially aligned orifices through the vertical course of inlet ports or slots.

19. The liner of claim 2 further comprising a third injector having a third series of axially aligned orifices and defining a third vertical axis coupled to a third fluid supply, wherein each of said third series of axially aligned orifices is in alignment with one of said plurality of wafer support positions and said third injector is positioned intermediate between said first injector and said second injector.

20. An across-flow liner comprising:
a cylinder having a sealed end and an open end, the open end adapted to receive a batch wafer carrier having a plurality of wafer support positions therethrough, said cylinder having a plurality of vertically displaced exhaust ports or slots wherein at least one of said plurality of vertically displaced exhaust ports or slots is in alignment with at least two of said plurality of wafer support positions; and
a first injector having a first series of axially aligned orifices, a first injector height and defining a first vertical axis, said first injector coupled to a first fluid supply and each of said first series of axially aligned orifices is in alignment with one of said plurality of wafer support positions.

21. The liner of claim 20 further comprising a second injector having a second series of axially aligned orifices, a second injector height and defining a second vertical axis, said second injector coupled to a second fluid supply such that each of said second series of axially aligned orifices is in alignment with one of said plurality of wafer support positions.

22. The liner of claim 21 wherein said first injector and said second injector are displaced around said cylinder to define an angle θ relative to a wafer in one of said plurality of wafer support positions, wherein θ is between 5 and 310 degrees.

23. The liner of claim 22 wherein θ is between 100 and 140 degrees and said first injector defines an angle ψ through the center of the wafer substrate through the middle of one of said plurality of vertically displaced exhaust ports or slots where ψ is between 100 and 140 degrees.

24. The liner of claim 22 wherein θ is between 150 and 210 degrees and further comprising a second plurality of vertically displaced exhaust ports or apertures wherein said first injector defines an angle ψ through the center of the wafer substrate through said plurality of vertically displaced exhaust ports or slots where ψ is between 80 and 100 and said first injector defines an angle ψ' through said second plurality of vertically displaced exhaust ports or slots where ψ' is between 260 and 280 degrees.

25. The liner of claim 24 wherein the angle θ is between 170 and 190 degrees.

26. The liner of claim 24 wherein said first injector is located within a bulging section of said cylinder.

27. The liner of claim 21 wherein said cylinder has at least one bulging section and said first injector and said second injector are located in the at least one bulging section.

28. The liner of claim 27 wherein said first injector is located within a first bulging section and said second injector is located in a second bulging section of the at least one bulging section of said cylinder.

29. The liner of claim 27 wherein said first injector and said second injector are located within a unified bulging section of the at least one bulging section of said liner.

30. The liner of claim 21 wherein the first series of axially aligned orifices define an angle α through the first vertical axis relative to a center of a wafer substrate located in one of said plurality of wafer support positions, wherein α is more than 90 and less than 270 degrees.

31. The liner of claim 30 wherein the angle α is selectively adjustable.

32. The liner of claim 20 further comprising a third injector having a third series of axially aligned orifices and defining a third vertical axis coupled to a third fluid supply, wherein each of said third series of axially aligned orifices is in alignment with one of said plurality of wafer support positions and said third injector is positioned intermediate between said first injector and said second injector.

33. A process of treating a batch of wafer substrates comprising:
inserting the batch of wafer substrates on a wafer carrier into a liner within a treatment reactor;
exposing the batch of wafer substrates to a first gas emitted from a first series of orifices in a first vertical injector, each orifice of said first series of orifices being in alignment with a wafer substrate of the batch of wafer substrates;
exposing the wafer substrates to a second gas emitted from a second series of orifices in a second vertical injector, each of said second series of orifices in alignment with the wafer substrate so as to provide an across-flow of said first gas and said second gas across the wafer substrate; and
exhausting said first gas and said second gas from said liner through a plurality of vertically displaced exhaust ports or slots.

34. The process of claim 33 wherein the batch of wafer substrates is simultaneously heated and exposed to a pressure less than atmospheric pressure during exposure to said first gas and said second gas.

35. The process of claim 33 wherein said first injector is circumferentially displaced relative to said second injector about the wafer substrate by an angle of at least 110 degrees.

36. The process of claim 35 wherein said first gas comprises radicals that flow across the wafer substrate and said second gas is provided in counter flow to said first gas.

37. The process of claim 33 wherein said first gas impinges on said liner prior to flowing across the wafer substrate.
